# EUROPÄISCHE PATENTSCHRIFT

(11) **EP 2 273 512 B1**
(45) Veröffentlichungstag und Bekanntmachung des Hinweises auf die Patenterteilung: **20.07.2016**
(21) Anmeldenummer: 10008590.1
(22) Anmeldetag: 18.11.2006
(51) Int. Cl.: H01B 1/12, H01L 51/30

(54) **Konjugierte Polymere enthaltend Triarylamin-arylvinylen-einheiten, deren Darstellung und Verwendung**
Conjugated polymers comprising triarylamine-arylenevinylene units, synthesis and use of the same
Polymères conjugués tannat des blocs de trisaryleneamine-arylene vinylene, leur représentation et utilisation

(30) Priorität: 17.12.2005 DE 102005060473
(43) Veröffentlichungstag der Anmeldung: 12.01.2011
(62) Teilanmeldung aus: 06818653.5
(73) Patentinhaber: Merck Patent GmbH, 64293 Darmstadt (DE)
(72) Erfinder: Buesing, Arne Dr., 65929 Frankfurt am Main (DE); Ludemann, Aurélie Dr., 60322 Frankfurt am Main (DE); Scheurich, René Peter Dr., 64846 Gross-Zimmern (DE)

(56) Entgegenhaltungen:
- EP-A- 1 277 824
- EP-A1- 1 281 745
- DE-A1- 19 532 574
- JP-A- 10 310 635
- US-A- 6 066 712
- ROST, HÖRHOLD, KREUDER,SPREITZER: "Novel ight-Emitting Poly(arylene vinylene) Copolymer conatining alternating phenylene and TPD units", SPIE CONFERENCE PROCEEDINGS, Bd. 3148, Nr. 18, 1. August 1997 (1997-08-01), - 1997, Seiten 373-381, XP002419822,

## Beschreibung

Die vorliegende Erfindung betrifft konjugierte Polymere enthaltend Styryl-Triarylamin-Struktureinheiten, ihre Verwendung in elektronischen Bauteilen, insbesondere in polymeren organischen Leuchtdioden, Monomere zu ihrer Herstellung, sowie solche Polymere enthaltende Bauteile und Leuchtdioden.

Konjugierte Polymere werden zur Zeit intensiv als vielversprechende Materialien in PLEDs (Polymer Light Emitting Diodes) untersucht. Ihre einfache Verarbeitung im Gegensatz zu SMOLEDs (Small Molecule Organic Light Emitting Diodes) verspricht eine kostengünstigere Herstellung von entsprechenden Leuchtdioden.

Dabei ist es für die Erzeugung aller drei Emissionsfarben nötig, bestimmte Comonomere in die entsprechenden Polymere einzupolymerisieren (vgl. z. B. WO 00/46321, WO 03/020790 und WO 02/077060). So ist dann in der Regel - ausgehend von einem blau emittierenden Grundpolymer ("backbone") - die Erzeugung der beiden anderen Primärfarben Rot und Grün möglich.

Die konjugierten Polymere gemäß Stand der Technik zeigen zum Teil schon gute Eigenschaften in der Anwendung in PLEDs. Trotz der in den letzten Jahren erzielten Fortschritte entsprechen diese Polymere allerdings noch nicht den Anforderungen, die an sie für hochwertige Anwendungen gestellt werden. So ist die Photostabilität der Polymere gemäß Stand der Technik noch keineswegs zufriedenstellend, d. h. die Polymere zersetzen sich teilweise unter dem Einfluss von Licht. Dies gilt insbesondere bei Bestrahlung mit blauem und UV-Licht. Als Folge verringert sich die Effizienz der Lichtemission der Polymere drastisch. Es wäre also wünschenswert, hier Polymere zur Verfügung zu haben, die diese Probleme nicht zeigen, deren weitere Eigenschaften im Device jedoch unverändert gut oder besser sind als die Device-Eigenschaften der Polymere gemäß Stand der Technik.

Nach Stand der Technik werden heute vor allem konjugierte Polymere auf Basis von Fluorenen, Indenofluorenen, Spirobifluorenen, Phenanthrenen und Dihydrophenanthrenen synthetisiert, um blau lumineszierende organische Leuchtdioden herstellen zu können. Dabei finden zunehmend Zweischichtaufbauten Akzeptanz, bei denen eine Emissionsschicht auf eine Injektionsschicht aufgebracht ist.

Die oben beschriebenen Systeme weisen jedoch Mängel in folgenden Parametern auf:
▪ Die Lebensdauer der blau emittierenden Polymere ist bei weitem noch nicht ausreichend für eine Verwendung in Massenprodukten.
▪ Die Effizienz der nach Stand der Technik hergestellten Polymere ist zu niedrig.
▪ Die Betriebsspannungen sind für die in Frage kommenden Anwendungen zu hoch.
▪ Die Materialien erleiden häufig während des Betriebes eine Verschiebung der Emissionscharakteristik.

Es wurde nun überraschend gefunden, daß konjugierte Polymere enthaltend Triarylamineinheiten, die durch eine Styrylgruppe substituiert sind, als blau oder grün emittierende Einheit sehr gute und den Stand der Technik übertreffende Eigenschaften aufweisen. Dies bezieht sich unter anderem auf die Photostabilität, aber auch auf die Effizienz der Polymere. Insbesondere wurde gefunden, daß der Einbau von Triphenylaminen, die durch eine Styrylgruppe substituiert sind, in die Emissionsschicht eines Polymers in geringen Konzentrationen zu einer Erhöhung der Lebensdauer, der Effizienz sowie zu einer Erniedrigung der Betriebsspannung bei geringer Verschiebung der Emissionsfarbe führt. Diese Polymere und deren Verwendung in PLEDs sind daher Gegenstand der vorliegenden Erfindung.

Polymere für OLEDs enthaltend Vinyl- und Triarylamingruppen sind in EP 1 281 745 A1, EP 1 277 824 A1 und US 6,066,712 offenbart. Polymere gemäß der vorliegenden Erfindung werden darin jedoch nicht gezeigt.

Polymere für Elektrolumineszenzvorrichtungen enthaltend Arylenvinylen- und Triarylamineinheiten werden in der DE 19532574 A1 sowie von Rost et al., in SPIE Conference Proceedings, Band 3148, Nr. 18, 1997, 373-381 offenbart.

Gegenstand der Erfindung sind konjugierte Polymere, dadurch gekennzeichnet, daß sie 1 bis 30 mol% einer oder mehrerer Einheiten gemäß Formel (1) enthalten 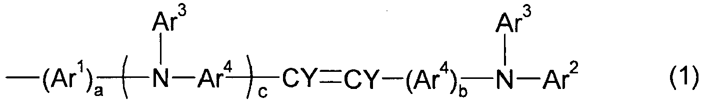 wobei die verwendeten Symbole und Indizes folgende Bedeutung besitzen:
Ar¹ ist bei jedem Auftreten gleich oder verschieden Phenyl oder Phenylen, welches ein- oder mehrfach durch R¹ substituiert sein kann,
Ar² ist bei jedem Auftreten gleich oder verschieden Phenyl oder Phenylen, welches ein- oder mehrfach durch R² substituiert sein kann,
Ar³ ist bei jedem Auftreten gleich oder verschieden Phenyl oder Phenylen, welches ein- oder mehrfach durch R³ substituiert sein kann,
Ar⁴ ist bei jedem Auftreten gleich oder verschieden Phenylen, 4,4'-Biphenylen, 9,9-disubstituiertem Fluoren-2,7-diyl, 6,6,12,12-tetrasubstituiertem Indenofluoren-2,8-diyl oder Spirobifluoren-2,7-diyl, wobei diese Gruppen ein- oder mehrfach durch R⁵ substituiert sein können, und R⁵ eine der für R⁴ angegebenen Bedeutungen besitzt,
Y ist bei jedem Auftreten H,
R¹⁻⁴ ist bei jedem Auftreten gleich oder verschieden H oder ein Kohlenwasserstoffrest mit 1 bis 40 C-Atomen, wobei auch zwei oder mehrere der Reste R¹⁻⁴ miteinander ein aliphatisches oder aromatisches, mono- oder polycyclisches Ringsystem bilden können, R¹, R² und R³ können auch eine kovalente Verknüpfung im Polymer bedeuten,
a ist bei jedem Auftreten gleich oder verschieden 1, 2 oder 3,
b ist bei jedem Auftreten gleich oder verschieden 1, 2 oder 3,
c ist bei jedem Auftreten gleich oder verschieden 0 oder 1,
sowie weitere Struktureinheiten
ausgewählt aus den Gruppen der Fluorenylene, Spirobifluorenylenen, Dihydrophenanthrenylene, Tetrahydropyrenylene, Stilbenylene, Bisstyrylarylene, 1,4-Phenylene, 1,4-Naphthylene, 1,4- oder 9,10-Anthrylene, 1,6- oder 2,7- oder 4,9-Pyrenylene, 3,9- oder 3,10-Perylenylene, 2,7- oder 3,6-Phenanthrenylene, 4,4'-Biphenylylene, 4,4"-Terphenylylene oder 4,4'-Bi-1,1'-naphthylylene,
ausgewählt aus den Gruppen der Triarylamine, Benzidine, Tetraarylen-para-phenylendiamine, Phenothiazine, Phenoxazine, Dihydrophenazine, Thianthrene, Dibenzo-p-dioxine, Phenoxathiine, Carbazole, Azulene, Thiophene, Pyrrole oder Furane, und/oder
ausgewählt aus den Gruppen Pyridine, Pyrimidine, Pyridazine, Pyrazine, Anthracene, Oxadiazole, Chinoline, Chinoxaline oder Phenazine.

Die Verknüpfung der Einheiten der Formel (1) zu benachbarten Einheiten in den erfindungsgemäßen Polymeren kann entlang der Polymerhauptkette oder auch in der Polymerseitenkette erfolgen. Besonders bevorzugt sind Polymere enthaltend eine oder mehrere Einheiten der Formel (1), vorzugsweise in der Polymerhauptkette, worin Ar² einen Substituenten R² aufweist, der eine Verknüpfung bedeutet.

Ferner bevorzugt sind Polymere enthaltend eine oder mehrere Einheiten der Formel (1), vorzugsweise in der Polymerseitenkette, worin Ar² und Ar³ keine Substituenten R² oder R³ aufweisen, die eine Verknüpfung bedeuten.

Ferner bevorzugt sind verzweigte Polymere enthaltend eine oder mehrere Einheiten der Formel (1), worin Ar² und ein oder mehrere Reste Ar³ jeweils einen Substituenten R² bzw. R³ aufweisen, der eine Verknüpfung bedeutet, d.h. Polymere enthaltend mindestens eine Einheit der Formel (1) als Verzweigungspunkt.

Auch wenn dies aus der Beschreibung hervorgeht, sei hier nochmals explizit darauf verwiesen, daß die Struktureinheiten gemäß Formel (1) unsymmetrisch substituiert sein können, d. h. daß an einer Einheit unterschiedliche Substituenten R¹⁻⁴ vorhanden sein können.

Der Begriff "Kohlenstoffrest" bedeutet vor- und nachstehend einen ein- oder mehrbindigen organischen Rest enthaltend mindestens ein Kohlenstoffatom, wobei dieser entweder keine weiteren Atome enthält (wie z.B. -C≡C-), oder gegebenenfalls ein oder mehrere weitere Atome wie beispielsweise N, O, S, P, Si, Se, As, Te oder Ge enthält (z.B. Carbonyl etc.). Der Begriff "Kohlenwasserstoffrest" bedeutet einen Kohlenstoffrest, der zusätzlich ein oder mehrere H-Atome und gegebenenfalls ein oder mehrere Heteroatome wie beispielsweise N, O, S, P, Si, Se, As, Te oder Ge enthält.

Der Begriff "Aryl" bedeutet eine aromatische Kohlenstoffgruppe oder eine davon abgeleitete Gruppe. Der Begriff "Heteroaryl" bedeutet "Aryl" gemäß vorstehender Definition, enthaltend ein oder mehrere Heteroatome.

Der Kohlenstoff- oder Kohlenwasserstoffrest kann eine gesättigte oder ungesättigte Gruppe sein. Ungesättigte Gruppen sind beispielsweise Aryl- , Alkenyl- oder Alkinylgruppen. Ein Kohlenstoff- oder Kohlenwasserstoffrest mit mehr als 3 C-Atomen kann geradkettig, verzweigt und/oder cyclisch sein, und kann auch Spiroverküpfungen oder kondensierte Ringe aufweisen.

Weitere bevorzugte Kohlenstoff- und Kohlenwasserstoffreste sind geradkettiges, verzweigtes oder cyclisches Alkyl mit 1 bis 40, vorzugsweise 1 bis 22 C-Atomen, welches unsubstituiert oder durch F, Cl, Br, I oder CN ein- oder mehrfach substituiert ist, und worin ein mehrere nicht benachbarte CH₂-Gruppen jeweils unabhängig voneinander durch-C(R⁰)=C(R⁰)- -C≡C-, -N(R⁰)-, -O-, -S-, -CO-, -CO-O-, -O-CO-, -S-CO-, - CO-S-, -O-CO-O- so ersetzt sein können, daß O- und/oder S-Atome nicht direkt miteinander verknüpft sind, oder optional ein- oder mehrfach durch R substituiertes Aryl mit 5 bis 40 C-Atomen, worin auch ein oder mehrere C-Atome durch O, S oder N ersetzt sein können, wobei R und R⁰ die oben angegebenen Bedeutungen haben.

Besonders bevorzugte Kohlenstoff- und Kohlenwasserstoffreste sind geradkettiges, verzweigtes oder cyclisches, Alkenyl, Alkinyl, Alkoxy, Alkylcarbonyl, Alkoxycarbonyl, Alkylcarbonyloxy und Alkoxycarbonyloxy mit 1 bis 40, vorzugsweise 1 bis 25, besonders bevorzugt 1 bis 18 C-Atomen, gegebenfalls substituiertes Aryl oder Aryloxy mit 5 bis 40, vorzugsweise 5 bis 25 C-Atomen, oder gegebenfalls substituiertes Alkylaryl, Arylalkyl, Alkylaryloxy, Arylalkyloxy, Arylcarbonyl, Aryloxycarbonyl, Arylcarbonyloxy und Aryloxycarbonyloxy mit 5 bis 40, vorzugsweise 5 bis 25 C-Atomen.

Ganz besonders bevorzugte Kohlenstoff- und Kohlenwasserstoffreste sind C₁-C₄₀ Alkyl, C₂-C₄₀ Alkenyl, C₂-C₄₀ Alkinyl, C₃-C₄₀ Allyl, C₄-C₄₀ Alkyldienyl, C₄-C₄₀ Polyenyl, C₆-C₄₀ Aryl, C₆-C₄₀ Alkylaryl, C₆-C₄₀ Arylalkyl, C₆-C₄₀ Alkylaryloxy, C₆-C₄₀ Arylalkyloxy, C₆-C₄₀ Heteroaryl, C₄-C₄₀ Cycloalkyl, C₄-C₄₀ Cycloalkenyl, etc. Besonders bevorzugt sind C₁-C₂₂ Alkyl, C₂-C₂₂ Alkenyl, C₂ -C₂₂ Alkinyl, C₃-C₂₂ Allyl, C₄-C₂₂ Alkyldienyl, C₆-C₁₂ Aryl, C₆-C₂₀ Arylalkyl und C₆-C₂₀ Heteroaryl.

Bevorzugte Alkylgruppen sind beispielsweise Methyl, Ethyl, n-Propyl, Isopropyl, n-Butyl, Isobutyl, s-Butyl, t-Butyl, 2-Methylbutyl, n-Pentyl, s-Pentyl, Cyclopentyl, n-Hexyl, Cyclohexyl, 2-Ethylhexyl, n-Heptyl, Cycloheptyl, 1,1,5-Trimethylheptyl, n-Octyl, Cyclooctyl, Dodecanyl, Trifluoromethyl, Perfluoro-n-butyl, 2,2,2-Trifluoroethyl, Perfluorooctyl, Perfluorohexyl etc.

Bevorzugte Alkenylgruppen sind beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl etc.

Bevorzugte Alkinylgruppen sind beispielsweise Ethinyl, Propinyl, Butinyl, Pentinyl, Hexinyl, Octinyl etc.

Bevorzugte Alkoxygruppen sind beispielsweise Methoxy, Ethoxy, 2-Methoxyethoxy, n-Propoxy, i-Propoxy, n-Butoxy, i-Butoxy, s-Butoxy, t-Butoxy, 2-Methylbutoxy, n-Pentoxy, n-Hexoxy, n-Heptoxy, n-Octoxy, n-Nonoxy, n-Decoxy, etc.

Bevorzugte Aminogruppen sind beispielsweise Dimethylamino, Methylamino, Methylphenylamino, Phenylamino, etc.

Arylgruppen können monocyclisch oder polycyclisch sein, d.h. sie können einen Ring (beispielsweise Phenyl) oder zwei oder mehr Ringe aufweisen, welche auch kondensiert (beispielsweise Naphthyl) oder kovalent verknüpft sein können (beispielsweise Biphenyl), oder eine Kombination von kondensierten und verknüpften Ringen beinhalten. Bevorzugt sind vollständig konjugierte Arylgruppen.

Bevorzugte Arylgruppen sind beispielsweise Phenyl, Biphenyl, Triphenyl, [1,1':3',1"]Terphenyl-2'-yl, Naphthyl, Anthracen, Binaphthyl, Phenanthren, Pyren, Dihydropyren, Chrysen, Perylen, Tetracen, Pentacen, Benzpyren, Fluoren, Inden, Indenofluoren, Spirobifluoren, etc.

Bevorzugte Heteroarylgruppen sind beispielsweise 5-gliedrige Ringe wie Pyrrol, Pyrazol, Imidazol, 1,2,3-Triazol, 1,2,4-Triazol, Tetrazol, Furan, Thiophen, Selenophen, Oxazol, Isoxazol, 1,2-Thiazol, 1,3-Thiazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 6-gliedrige Ringe wie Pyridin, Pyridazin, Pyrimidin, Pyrazin, 1,3,5-Triazin, 1,2,4-Triazin, 1,2,3-Triazin, 1,2,4,5-Tetrazin, 1,2,3,4-Tetrazin, 1,2,3,5-Tetrazin, oder kondensierte Gruppen wie Indol, Isoindol, Indolizin, Indazol, Benzimidazol, Benzotriazol, Purin, Naphthimidazol, Phenanthrimidazol, Pyridimidazol, Pyrazinimidazol, Chinoxalinimidazol, Benzoxazol, Naphthoxazol, Anthroxazol, Phenanthroxazol, Isoxazol, Benzothiazol, Benzofuran, Isobenzofuran, Dibenzofuran, Chinolin, Isochinolin, Pteridin, Benzo-5,6-chinolin, Benzo-6,7-chinolin, Benzo-7,8-chinolin, Benzoisochinolin, Acridin, Phenothiazin, Phenoxazin, Benzopyridazin, Benzopyrimidin, Chinoxalin, Phenazin, Naphthyridin, Azacarbazol, Benzocarbolin, Phenanthridin, Phenanthrolin, Thieno[2,3b]thiophen, Thieno[3,2b]thiophen, Dithienothiophen, Isobenzothiophen, Dibenzothiophen, Benzothiadiazothiophen, oder Kombinationen dieser Gruppen. Die Heteroarylgruppen können auch mit Alkyl, Alkoxy, Thioalkyl, Fluor, Fluoralkyl oder weiteren Aryl- oder Heteroarylgruppen substituiert sein.

Die Aryl-, Heteroaryl-, Kohlenstoff- und Kohlenwasserstoffreste weisen gegebenfalls einen oder mehrere Substituenten auf, welche vorzugsweise ausgewählt sind aus der Gruppe enthaltend Silyl, Sulfo, Sulfonyl, Formyl, Amin, Imin, Nitril, Mercapto, Nitro, Halogen, C₁-₁₂ Alkyl, C₆₋₁₂ Aryl, C₁₋₁₂ Alkoxy, Hydroxy, oder Kombinationen dieser Gruppen.

Bevorzugte Substituenten sind beispielsweise löslichkeitsfördernde Gruppen wie Alkyl oder Alkoxy, elektronenziehende Gruppen wie Fluor, Nitro oder Nitril, oder Substituenten zur Erhöhung der Glastemperatur (Tg) im Polymer, insbesondere voluminöse Gruppen wie z.B. t-Butyl oder gegebenfalls substituierte Arylgruppen.

Weitere bevorzugte Substituenten sind beispielsweise F, Cl, Br, I, -CN,-NO₂, -NCO, -NCS, -OCN, -SCN, -C(=O)N(R⁰)₂, -C(=O)X, -C(=O)R⁰,-N(R⁰)₂, worin X Halogen bedeutet und R⁰ die oben angegebene Bedeutung besitzt, gegebenfalls substituiertes Silyl, Aryl mit 4 bis 40, vorzugsweise 6 bis 20 C Atomen, und geradkettiges oder verzweigtes Alkyl, Alkoxy, Alkylcarbonyl, Alkoxycarbonyl, Alkylcarbonlyoxy oder Alkoxycarbonyloxy mit 1 to 22 C-Atomen, worin ein oder mehrere H-Atome gegebenfalls durch F oder Cl ersetzt sein können.

Die Begriffe "Alkyl", "Aryl", "Heteroaryl" etc. umfassen auch mehrbindige Gruppen, beispielsweise Alkylen, Arylen, Heteroarylen etc.

"Halogen" bedeutet F, Cl, Br oder I.

"Konjugierte Polymere" im Sinne dieser Erfindung sind Polymere, die in der Hauptkette hauptsächlich sp²-hybridisierte (bzw. gegebenenfalls auch sp-hybridisierte) Kohlenstoffatome, die auch durch entsprechende Heteroatome ersetzt sein können, enthalten. Dies bedeutet im einfachsten Fall abwechselndes Vorliegen von Doppel- und Einfachbindungen in der Hauptkette, aber auch Polymere mit Einheiten wie beispielsweise metaverknüpftes Phenylen sollen im Sinne dieser Erfindung als konjugierte Polymere gelten. "Hauptsächlich" meint, daß natürlich (unwillkürlich) auftretende Defekte, die zu Konjugationsunterbrechungen führen, den Begriff "konjugiertes Polymer" nicht entwerten. Des Weiteren wird in diesem Anmeldetext ebenfalls als "konjugiert" bezeichnet, wenn sich in der Hauptkette beispielsweise Arylamineinheiten, Arylphosphineinheiten und/oder bestimmte Heterocyclen (d. h. Konjugation über N-, O-, P- oder S-Atome) und/oder metallorganische Komplexe (d. h. Konjugation über das Metallatom) befinden.

Die Einheiten gemäß Formel (1) können erfindungsgemäß in die Haupt- oder in die Seitenkette des Polymers eingebaut werden. Bei Einbau in die Seitenkette besteht die Möglichkeit, daß die Einheit gemäß Formel (1) in Konjugation mit der Polymerhauptkette steht oder daß sie nicht-konjugiert zur Polymerhauptkette ist.

In einer bevorzugten Ausführungsform der Erfindung steht die Einheit gemäß Formel (1) in Konjugation mit der Polymerhauptkette. Dies kann einerseits dadurch erreicht werden, daß diese Einheit in die Hauptkette des Polymers so eingebaut wird, daß dadurch die Konjugation des Polymers, wie oben beschrieben, erhalten bleibt. Andererseits kann diese Einheit auch in die Seitenkette des Polymers so verknüpft werden, daß eine Konjugation zur Hauptkette des Polymers besteht. Dies ist beispielsweise der Fall, wenn die Verknüpfung mit der Hauptkette nur über sp²-hybridisierte (bzw. gegebenenfalls auch über sp-hybridisierte) Kohlenstoffatome, die auch durch entsprechende Heteroatome ersetzt sein können, erfolgt. Erfolgt die Verknüpfung jedoch durch Einheiten, wie beispielsweise einfache (Thio)Etherbrücken, Ester, Amide oder Alkylenketten, so ist die Struktureinheit gemäß Formel (1) als nicht-konjugiert zur Hauptkette definiert.

Die Anknüpfung der Einheiten der Formel (1) an die Hauptkette kann direkt oder über eine oder mehrere zusätzliche Einheiten erfolgen. Bevorzugte Einheiten zur Verknüpfung sind optional substituierte, geradkettige, verzweigte oder cyclische Alkylengruppen, Alkenylengrupen oder Alkinylengruppen, insbesondere optional substituierte C=C-Doppelbindungen, C≡C-Dreifachbindungen, oder aromatische Einheiten, weitere zu Formel (1) identische oder verschiedene Di- und Triarylaminoeinheiten, Arylenvinyleneinheiten oder Arylenethinyleneinheiten. Bevorzugt ist eine Verknüpfung in Konjugation zur Hauptkette.

Die Reste Ar¹⁻³ in Formel (1) bedeuten Phenyl (als einbindiger Rest) oder Phenylen (als zweibindiger Rest), wobei diese Gruppen ein- oder mehrfach durch R⁵ substituiert sein können, und R⁵ eine der in Formel (1) für R⁴ angegebenen Bedeutungen besitzt. Falls einer der Phenylenreste Ar¹⁻³ eine Verknüpfung zu einer benachbarten Einheit aufweist, so befindet sich diese in 2-, 3- oder 4-Position, vorzugsweise in 4-Position.

Die Reste Ar⁴ in Formel (1) sind ausgewählt aus Phenylen, insbesondere 1,4-Phenylen, 4,4'-Biphenylen, 9,9-disubstituiertem Fluoren-2,7-diyl, oder 6,6,12,12-tetrasubstituiertem Indenofluoren-2,8-diyl oder Spirobifluoren-2,7-diyl, wobei diese Gruppen ein- oder mehrfach durch R⁵ wie oben definiert substituiert sein können.

Die Gruppen Y in Formel (1) bedeuten H.

Besonders bevorzugt sind erfindungsgemäße Polymere enthaltend eine oder mehrere Einheiten der Formel (1) ausgewählt aus folgenden Unterformeln: 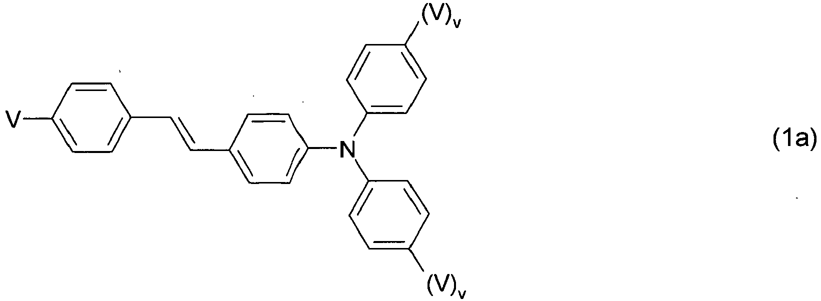 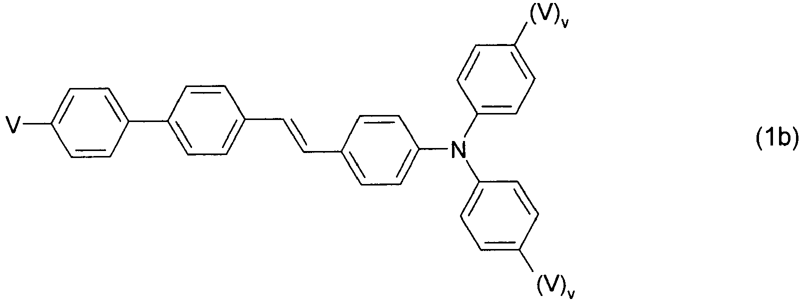 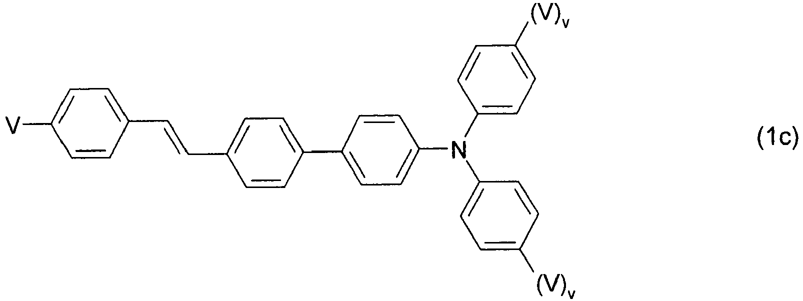 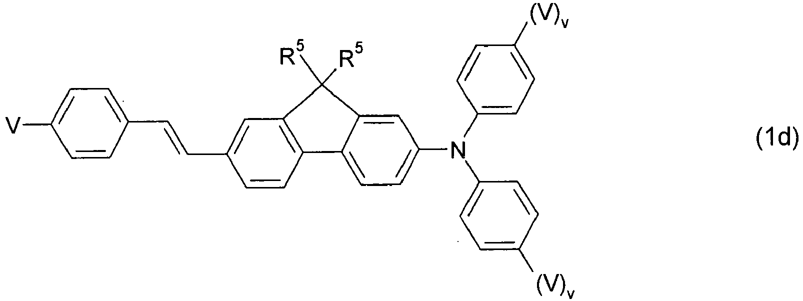 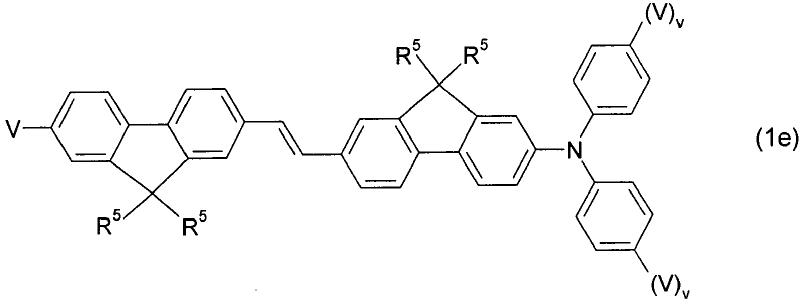 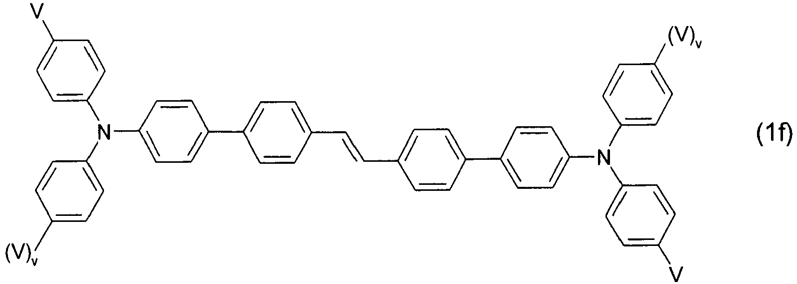 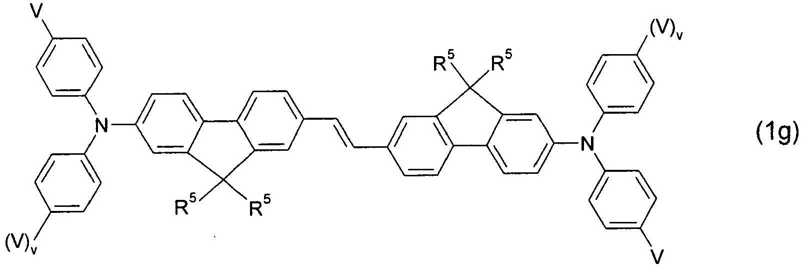 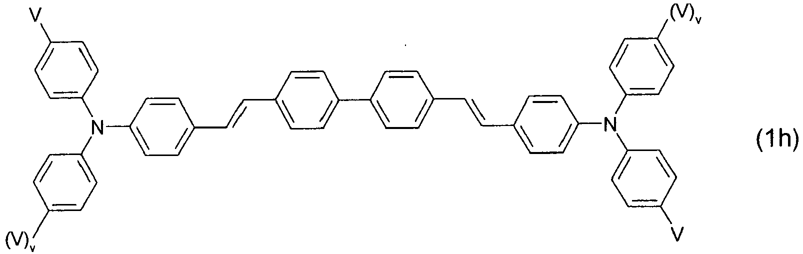 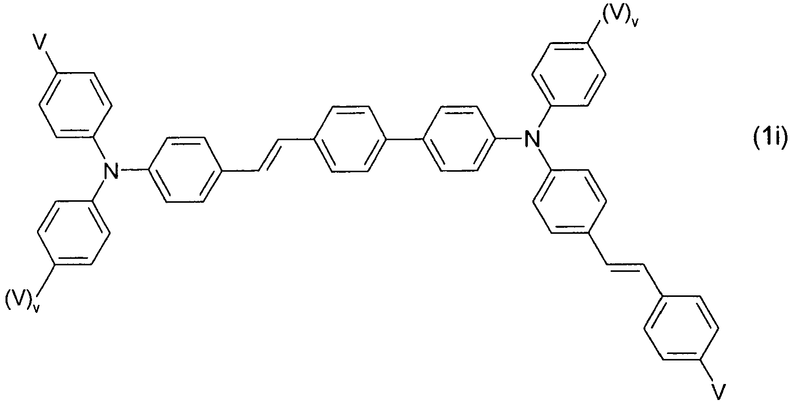 worin V eine kovalente Verknüpfung im Polymer und v 0 oder 1 bedeutet, und R⁵ bei jedem Auftreten gleich oder verschieden eine der für R⁴ in Formel (1) angegebenen Bedeutungen besitzt. Die Phenylringe können auch ein- oder mehrfach durch R⁵ substituiert sein.

Die erfindungsgemäßen konjugierten Polymere enthalten 1 bis 30 mol%, vorzugsweise 1 bis 10 mol% einer oder mehrerer Einheiten der Formel (1).

Die Struktureinheit der Formel (1) ist gut und in hohen Ausbeuten zugänglich. Verbindungen mit dieser Struktureinheit, wie beispielsweise die folgende Verbindung 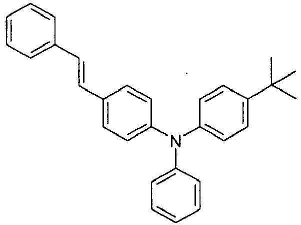 zeigen im Feststoff intensive grünblaue Lumineszenz. In geringer Konzentration in Lösung dagegen erhält man tiefblaue Lumineszenz. Ein eventuell nötiges Einstellen der Emissionsfarbe läßt sich durch Wahl der Substituenten am Phenylring, der nicht in die Polymerkette eingebaut ist, vornehmen.

Die Verbindungen der Formel I können nach dem Fachmann bekannten und in der Literatur beschriebenen Methoden hergestellt werden. Weitere geeignete und bevorzugte Syntheseverfahren finden sich in den Beispielen. Die Verbindungen der Formel I können beispielsweise hergestellt werden, indem man optional substituiertes Phenyl-4-Bromphenyl-4-Formylphenylamin, das nach literaturbekannten Verfahren hergestellt werde kann, mit optional substituiertem (4-Brombenzyl-methylen)-diethylphosphonat in Gegenwart einer Base umsetzt.

Die vor- und nachstehend beschriebenen Verfahren sind ein weiterer Gegenstand der Erfindung.

Die erfindungsgemäßen Polymere enthalten neben Einheiten gemäß Formel (1) noch weitere Strukturelemente, und sind somit als Copolymere zu bezeichnen. Die weiteren Comonomere sind zwar notwendig zur Synthese der erfindungsgemäßen Copolymere; sie sind allerdings nicht selbst Gegenstand der vorliegenden Erfindung und sind somit durch Zitat zu beschreiben. Hier sei vor allem auch auf die relativ umfangreichen Auflistungen in WO 02/077060, WO 2005/014689 und die darin aufgeführten Zitate verwiesen. Diese weiteren Struktureinheiten können beispielsweise aus den im Folgenden beschriebenen Klassen stammen:
- Gruppe 1:: Comonomere, welche das Polymer-Grundgerüst darstellen.
- Gruppe 2:: Comonomere, welche die Lochinjektions- und/oder -transporteigenschaften der Polymere erhöhen.
- Gruppe 3:: Comonomere, welche die Elektroneninjektions- und/oder -transporteigenschaften der Polymere deutlich erhöhen.
- Gruppe 4:: Comonomere, die Kombinationen von Einzeleinheiten der Gruppe 2 und Gruppe 3 aufweisen.

Geeignete Einheiten für die oben genannten Gruppen werden im Folgenden beschrieben.

Gruppe 1 - Comonomere, welche das Polymer-Grundgerüst darstellen: Geeignete Einheiten sind unter anderem Fluoren-Derivate wie z. B. in EP 0842208, WO 99/54385, WO 00/22027, WO 00/22026 oder WO 00/46321 offenbart, ferner Spirobifluoren-Derivate wie z. B. in EP 0707020, EP 0894107 und WO 03/020790 offenbart, oder Dihydrophenanthren-Derivate wie in WO 2005/014689 offenbart. Es ist auch möglich, eine Kombination von zwei oder mehr dieser MonomerEinheiten zu verwenden, wie z.B. in WO 02/077060 beschrieben. Es sind auch andere Strukturelemente möglich, die die Morphologie, aber auch die Emissionsfarbe der resultierenden Polymere beeinflussen können. Bevorzugt sind dabei substituierte oder unsubstituierte aromatische Strukturen, die 6 bis 40 C-Atome aufweisen oder auch Stilben- oder Bisstyrylarylenderivate, wie z. B. 1,4-Phenylen-, 1,4-Naphthylen-, 1,4-oder 9,10-Anthrylen-, 1,6- oder 2,7- oder 4,9-Pyrenylen-, Tetrahydropyrenylen-, 3,9- oder 3,10-Perylenylen-, 2,7- oder 3,6-Phenanthrenylen-, 4,4'-Biphenylylen-, 4,4"-Terphenylylen-, 4,4'-Bi-1,1'-naphthylylen-, 4,4'-Stilbenyl- oder 4,4"-Bisstyrylarylenderivaten.

Bevorzugte Einheiten für das Polymergrundgerüst sind Spirobifluorene, Indenofluorene, Phenanthrene und Dihydrophenanthrene.

Geeignete Einheiten der Gruppe 1 können zweibindige Einheiten gemäß den folgenden Formeln sein, worin die gestrichelte Linie die Verknüpfung zur benachbarten Einheit bedeutet: 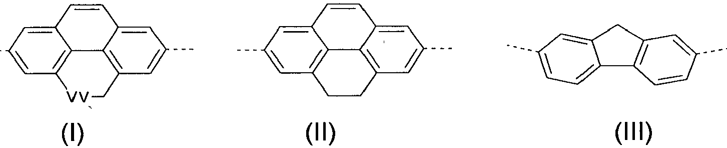 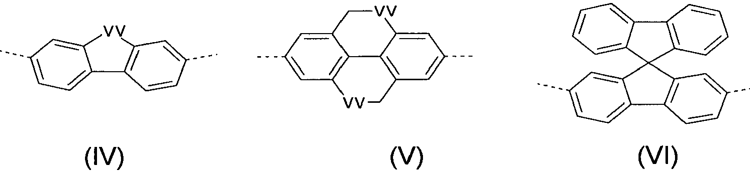 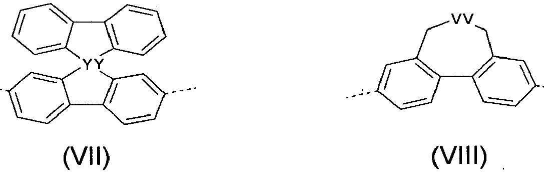 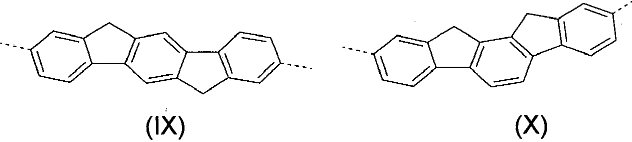 wobei die verschiedenen Positionen auch durch einen oder mehrere Substituenten R⁵ wie oben definiert substituiert sein können, YY Si oder Ge bedeutet und W O, S oder Se bedeutet.

Gruppe 2 - Comonomere, welche die Lochinjektions- und/oder -transporteigenschaften der Polymere erhöhen:
Dies sind aromatische Amine oder elektronenreiche Heterocyclen, aussgewählt aus substituierten oder unsubstituierten Triarylaminen, Benzidinen, Tetraarylen-para-phenylendiaminen,
Phenothiazinen, Phenoxazinen, Dihydrophenazinen, Thianthrenen, Dibenzo-p-dioxinen, Phenoxathiinen, Carbazolen, Azulenen, Thiophenen, Pyrrolen und Furanen.

Einheiten der Gruppe 2 können zweibindige Einheiten gemäß den folgenden Formeln sein, worin die gestrichelte Linie die Verknüpfung zur benachbarten Einheit bedeutet: 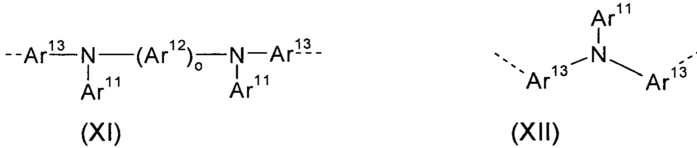 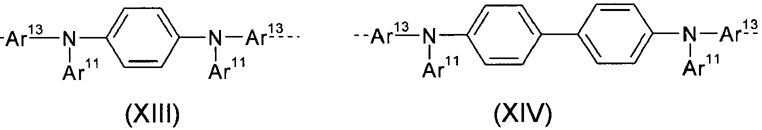 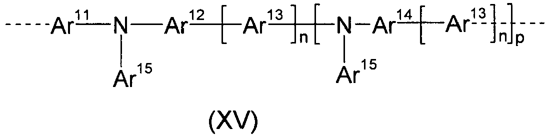 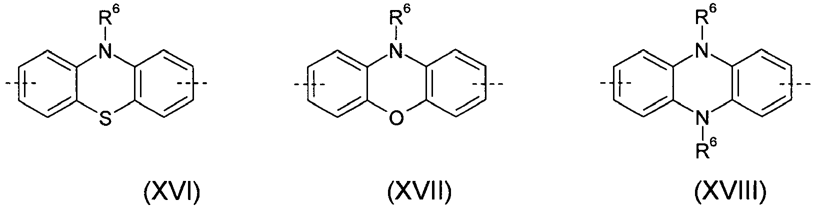 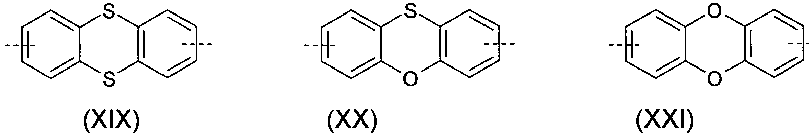 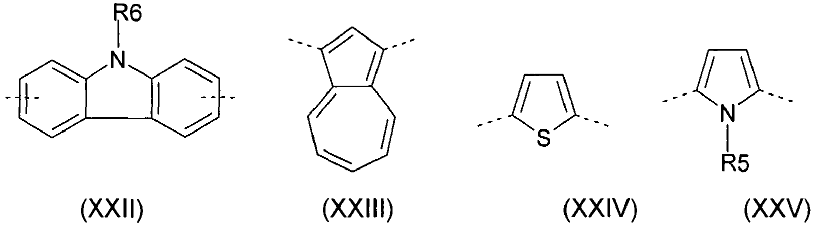 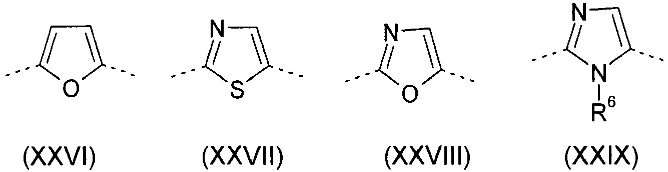 wobei R⁶ eine der für R⁵ angegebenen Bedeutungen besitzt, die verschiedenen Formeln an den freien Positionen auch zusätzlich durch einen oder mehrere Substituenten R⁵ substituiert sein können und die Symbole und Indizes folgendes bedeuten:
n ist gleich oder verschieden bei jedem Auftreten 0, 1, oder 2,
p ist gleich oder verschieden bei jedem Auftreten 0, 1 oder 2, bevorzugt 0 oder 1,
o ist gleich oder verschieden bei jedem Auftreten 1, 2 oder 3, bevorzugt 1 oder 2,
Ar¹¹, Ar¹³ sind bei jedem Auftreten gleich oder verschieden ein aromatisches oder heteroaromatisches Ringsystem mit 2 bis 40 C-Atomen, welches durch R⁵ ein- oder mehrfach substituiert oder auch unsubstituiert sein kann; die möglichen Substituenten R⁵ können dabei potentiell an jeder freien Position sitzen,
Ar¹², Ar¹⁴ sind bei jedem Auftreten gleich oder verschieden Ar¹¹, Ar¹³ oder eine substituierte oder unsubstituierte Stilbenylen- bzw. Tolanyleneinheit,
Ar¹⁵ ist gleich oder verschieden bei jedem Auftreten entweder ein System gemäß Ar¹¹ oder ein aromatischen oder heteroaromatischen Ringsystem mit 9 bis 40 aromatischen Atomen (C- oder Heteroatome), welches durch R⁵ ein- oder mehrfach substituiert oder unsubstituiert sein kann und welches aus mindestens zwei kondensierten Ringen besteht; die möglichen Substituenten R⁵ können dabei potentiell an jeder freien Position sitzen.

Gruppe 3 - Comonomere, welche die Elektroneninjektions- und/oder -transporteigenschaften der Polymere deutlich erhöhen:
Dies sind elektronenarme Aromaten oder Heterocyclen, ausgewählt aus substituierten oder unsubstituierten Pyridinen, Pyrimidinen, Pyridazinen, Pyrazinen, Anthracenen, Oxadiazolen, Chinolinen, Chinoxalinen oder Phenazinen.

Einheiten der Gruppe 3 können zweibindige Einheiten gemäß den folgenden Formeln sein, worin die gestrichelte Linie die Verknüpfung zur benachbarten Einheit bedeutet: 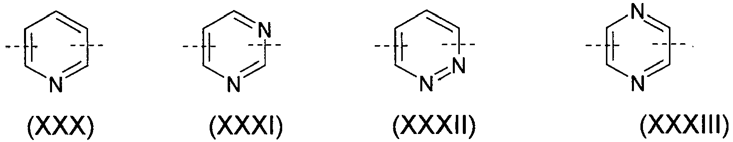 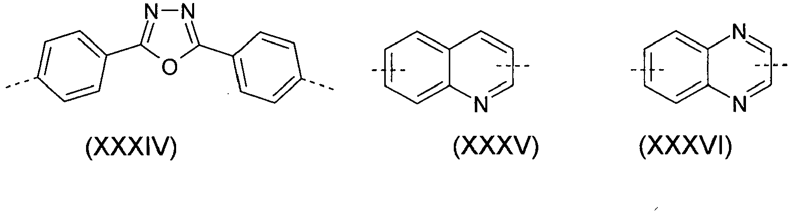 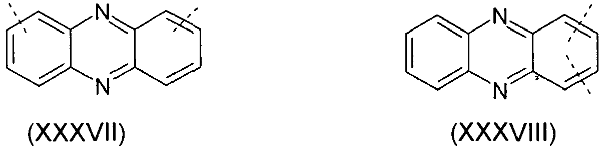 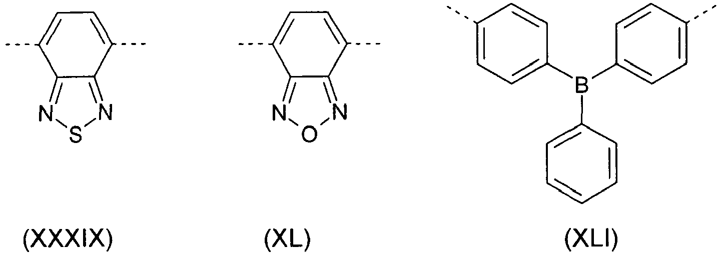 wobei die verschiedenen Formeln an den freien Positionen durch einen oder mehrere Substituenten R⁵ wie oben definiert substituiert sein können.

Gruppe 4 - Comonomere, die Kombinationen von Einzeleinheiten der Gruppe 2 und Gruppe 3 aufweisen:
Es ist auch möglich, daß die erfindungsgemäßen Polymeren Einheiten enthalten, in denen Strukturen, welche die Lochmobilität und welche die Elektronenmobilität erhöhen, direkt aneinander gebunden sind. Allerdings verschieben einige dieser Einheiten die Emissionsfarbe ins Gelbe oder Rote; ihre Verwendung in erfindungsgemäßen Polymeren zur Erzeugung blauer oder grüner Emission ist deshalb weniger bevorzugt.

Falls solche Einheiten der Gruppe 4 in den erfindungsgemäßen Polymeren enthalten sind, sind sie bevorzugt ausgewählt aus zweibindigen Einheiten gemäß den folgenden Formeln, worin die gestrichelte Linie die Verknüpfung zur benachbarten Einheit bedeutet: 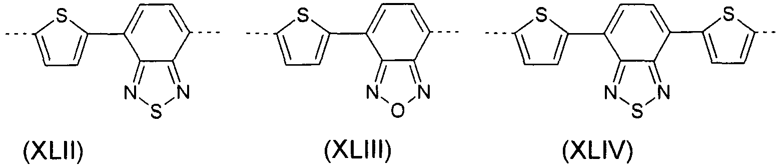 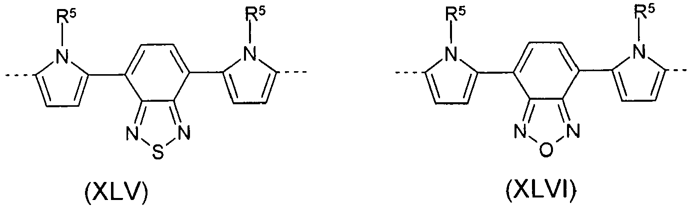 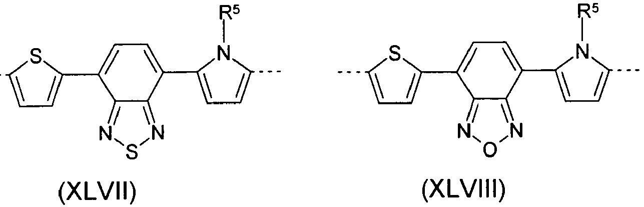 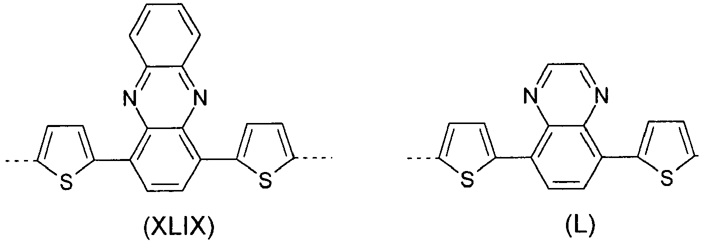 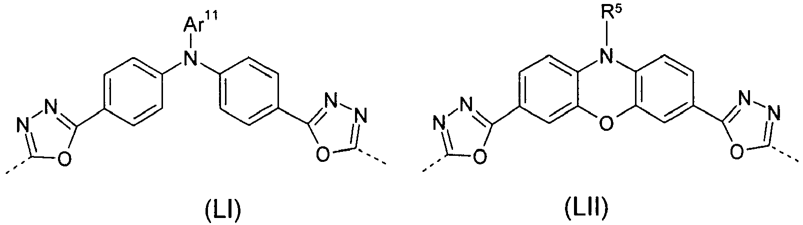 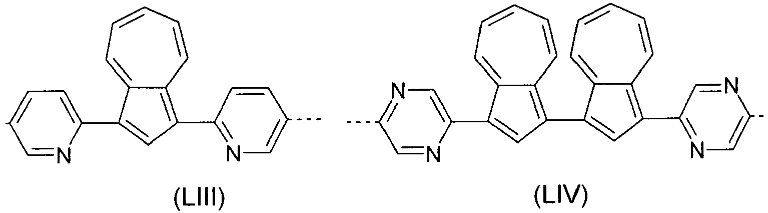 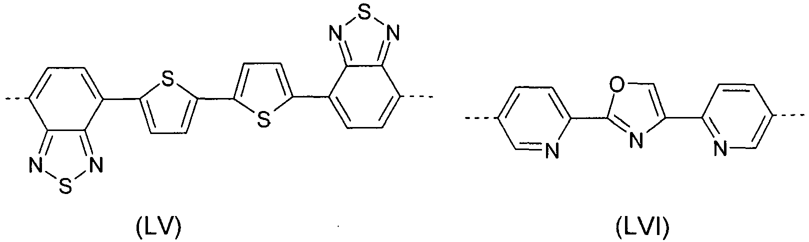 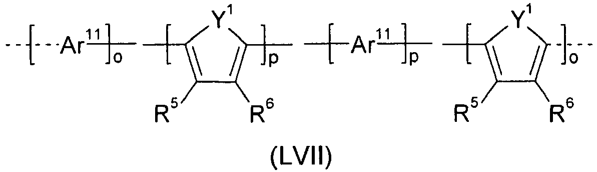 wobei die verschiedenen Formeln an den freien Positionen durch eine oder mehrere Substituenten R⁵ wie oben definiert substituiert sein können, die Symbole R⁵, R⁶, Ar¹¹, n, p und o die oben genannte Bedeutung besitzen und Y¹ bei jedem Auftreten gleich oder verschieden O, S, Se, N, P, Si oder Ge ist.

Es ist auch möglich, daß gleichzeitig mehr als eine Struktureinheit aus einer der Gruppen 1-4 vorliegt.

Das erfindungsgemäße Polymer kann weiterhin ebenfalls in die Haupt- oder Seitenkette gebundene Metallkomplexe enthalten, die im Allgemeinen aus einem oder mehreren Liganden und einem oder mehreren Metallzentren aufgebaut sind.

Bevorzugt sind erfindungsgemäße Polymere, die gleichzeitig neben Struktureinheiten gemäß Formel (1) zusätzlich noch ein oder mehrere Einheiten ausgewählt aus den Gruppen 1 bis 4 enthalten.

Bevorzugt sind dabei erfindungsgemäße Polymere, die neben Einheiten gemäß Formel (1) noch Einheiten aus der Gruppe 1 enthalten, besonders bevorzugt mindestens 50 mol% dieser Einheiten.

Ebenfalls bevorzugt ist es, wenn die erfindungsgemäßen Polymere Einheiten enthalten, die den Ladungstransport oder die Ladungsinjektion verbessern, also Einheiten aus Gruppe 2 und/oder 3; besonders bevorzugt ist ein Anteil von 1 - 30 mol% dieser Einheiten; ganz besonders bevorzugt ist ein Anteil von 1 - 10 mol% dieser Einheiten.

Besonders bevorzugt ist es weiterhin, wenn die erfindungsgemäßen Polymere Einheiten aus Gruppe 1 und Einheiten aus Gruppe 2 und/oder 3 enthalten, insbesondere mindestens 50 mol% Einheiten aus Gruppe 1 und 1 - 30 mol% Einheiten aus Gruppe 2 und/oder 3.

Die erfindungsgemäßen Polymere weisen in der Regel 10 bis 10000, bevorzugt 20 bis 5000, besonders bevorzugt 50 bis 2000 Wiederholeinheiten auf.

Die nötige Löslichkeit der Polymere wird v. a. durch die Substituenten an den verschiedenen Wiederholeinheiten gewährleistet, sowohl den Substituenten R und R¹⁻⁴ an Einheiten gemäß Formel (1), wie auch durch Substituenten an den anderen Wiederholeinheiten.

Die erfindungsgemäßen Polymere sind Copolymere. Die erfindungsgemäßen Copolymere können linear oder verzweigt (vernetzt) sein. Erfindungsgemäße Copolymere können dabei neben einer oder mehreren Strukturen gemäß Formel (1), oder deren bevorzugten Unterformeln, potentiell eine oder mehrere weitere Strukturen aus den oben aufgeführten Gruppen 1 bis 4 besitzen.

Die erfindungsgemäßen Copolymere können statistische, alternierende oder blockartige Strukturen aufweisen oder auch mehrere dieser Strukturen abwechselnd besitzen. Wie Copolymere mit blockartigen Strukturen erhalten werden können und welche weiteren Strukturelemente dafür besonders bevorzugt sind, ist beispielsweise ausführlich in WO 2005/014688 beschrieben. Diese ist via Zitat Bestandteil der vorliegenden Anmeldung. Ebenso sei an dieser Stelle nochmals hervorgehoben, daß das Polymer auch dendritische Strukturen haben kann.

Ebenso können Struktureinheiten gemäß Formel (1) als grün oder blau emittierende Comonomere für die Synthese rot emittierender Polymere verwendet werden.

Die erfindungsgemäßen Polymere werden in der Regel durch Polymerisation von mehreren Monomersorten hergestellt, von denen mindestens ein Monomer durch die Formel (1) beschrieben ist. Geeignete Polymerisationsreaktionen sind dem Fachmann bekannt und in der Literatur beschrieben. Besonders geeignete und bevorzugte Polymerisationsreaktionen, die alle zu C-C-Verknüpfungen führen, sind folgende:
(A) Polymerisation gemäß SUZUKI;
(B) Polymerisation gemäß YAMAMOTO;
(C) Polymerisation gemäß STILLE;

Wie die Polymerisation nach diesen Methoden durchgeführt werden kann und wie die Polymere dann vom Reaktionsmedium abgetrennt und aufgereinigt werden können, ist dem Fachmann bekannt und in der Literatur, beispielsweise in WO 2004/037887, im Detail beschrieben.

Die C-C-Verknüpfungen sind bevorzugt ausgewählt aus den Gruppen der SUZUKI-Kupplung, der YAMAMOTO-Kupplung und der STILLE-Kupplung.

Zur Synthese der Polymere werden die entsprechenden Monomere benötigt. Die Synthese von Einheiten aus Gruppe 1 bis 4 ist dem Fachmann bekannt und in der Literatur, beispielsweise in WO 2005/014689, beschrieben. Diese und die darin zitierte Literatur ist via Zitat Bestandteil der vorliegenden Anmeldung.

Monomere, die in erfindungsgemäßen Polymeren zu Struktureinheiten gemäß Formel (1) führen, sind vorzugsweise ausgewählt aus Formel (1) 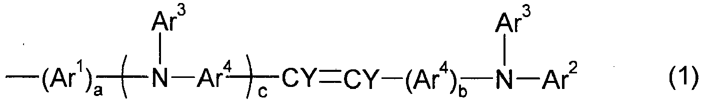 worin Ar¹⁻⁴, a, b und c die oben angegebenen Bedeutungen besitzen, und worin einer der Substituenten R¹ an Ar¹ und gegebenenfalls einer der Substituenten R² and Ar² und einer der Substituenten R³ an Ar³ jeweils unabhängig voneinander eine reaktive Gruppe Z bedeuten.

Neue Monomere, die im Polymer zu Einheiten gemäß Formel (1) führen, insbesondere neue Monomere der Formel (1) und ihrer bevorzugten Unterformeln, sind ebenfalls Gegenstand der vorliegenden Erfindung.

Die Gruppen Z sind ausgewählt aus Halogen, insbesondere Cl, Br, I, O-Tosylat, O-Triflat, O-SO₂R', B(OH)₂, B(OR')₂ oder Sn(R')₃, ferner O-Mesylat, O-Nonaflat, SiMe₂F, SiMeF₂, CR'=C(R')₂, oder C≡CH, worin R' optional substituiertes Alkyl oder Aryl bedeutet und zwei Gruppen R' ein aromatisches oder aliphatisches, mono- oder polycyclisches Ringsystem bilden können. "Aryl" und "Alkyl" besitzen vorzugsweise eine der oben angegebenen Bedeutungen.

Ferner bevorzugt sind Monomere gemäß den oben gezeigten Unterformeln (1a) - (1 i), worin die Reste V jeweils unabhängig voneinander Z bedeuten.

Die Monomere können durch Verfahren hergestellt werden, die dem Fachmann bekannt und in Standardwerken der organischen Chemie beschriebenen sind. Besonders geeignete und bevorzugte Verfahren sind in den Beispielen beschrieben.

Die erfindungsgemäßen Polymere weisen gegenüber den Polymeren gemäß Stand der Technik folgende Vorteile auf:
(1) Die erfindungsgemäßen Polymere zeigen eine höhere Photostabilität im Vergleich zu Polymeren gemäß Stand der Technik. Dies ist von entscheidender Bedeutung für die Anwendung dieser Polymere, da sie sich weder durch die durch Elektrolumineszenz freigesetzte Strahlung, noch durch von außen einfallende Strahlung zersetzen dürfen. Diese Eigenschaft ist bei Polymeren gemäß Stand der Technik noch mangelhaft.
(2) Die erfindungsgemäßen Polymere weisen (bei ansonsten gleicher oder ähnlicher Zusammensetzung) vergleichbare oder höhere Leuchteffizienzen in der Anwendung auf. Dies ist von enormer Bedeutung, da somit entweder gleiche Helligkeit bei geringerem Energieverbrauch erzielt werden kann, was vor allem bei mobilen Applikationen (Displays für Handys, Pager, PDA etc.), die auf Batterien und Akkus angewiesen sind, sehr wichtig ist. Umgekehrt erhält man bei gleichem Energieverbrauch höhere Helligkeiten, was beispielsweise für Beleuchtungsanwendungen interessant sein kann.
(3) Des Weiteren hat sich überraschend gezeigt, daß, wiederum im direkten Vergleich, die erfindungsgemäßen Polymere vergleichbare oder höhere operative Lebensdauern aufweisen.

Es kann außerdem bevorzugt sein, das erfindungsgemäße Polymer nicht als Reinsubstanz, sondern als Mischung (Blend) zusammen mit weiteren beliebigen polymeren, oligomeren, dendritischen oder niedermolekularen Substanzen zu verwenden. Diese können beispielsweise die elektronischen Eigenschaften verbessern oder selber emittieren. Solche Blends sind daher auch Bestandteil der vorliegenden Erfindung.

Gegenstand der Erfindung sind weiterhin Lösungen und Formulierungen aus einem oder mehreren erfindungsgemäßen Polymeren oder Blends in einem oder mehreren Lösungsmitteln. Wie Polymerlösungen hergestellt werden können, ist, ist dem Fachmann bekannt und beispielsweise in WO 02/072714, WO 03/019694 und der darin zitierten Literatur beschrieben.

Diese Lösungen können verwendet werden, um dünne Polymerschichten herzustellen, zum Beispiel durch Flächenbeschichtungsverfahren (z. B. Spin-coating) oder durch Druckverfahren (z. B. InkJet Printing).

Die erfindungsgemäßen Lösungen, Formulierungen, Blends oder Mischungen können gegebenfalls noch weitere Komponenten oder Zusätze enthalten, beispielsweise ein oder mehrere Additive ausgewählt aus der Gruppe enthaltend oberflächenaktive Substanzen, Schmiermittel, Netzhilfsmittel, Dispergierhilfsmittel, Haftvermittler, Hydrophobisierungsmittel, Fließverbesserer, Entschäumer, Entlüfter, Verdünner, Reaktiverdünner, Hilfsmittel zur Verbesserung der Kratzfestigkeit, Katalysatoren, Sensibilisatoren, Stabilisatoren z.B. gegen Licht, Hitze und Oxidation, Inhibitoren, Kettenübertragungsreagenzien, Comonomere, Farbstoffe, Pigmente und Nanopartikel.

Die erfindungsgemäßen Polymere können in PLEDs verwendet werden. Wie PLEDs hergestellt werden können, ist dem Fachmann bekannt und wird beispielsweise als allgemeines Verfahren ausführlich in WO 2004/070772 beschrieben, das entsprechend für den Einzelfall anzupassen ist.

Wie oben beschrieben, eignen sich die erfindungsgemäßen Polymere ganz besonders als Elektrolumineszenzmaterialien in derart hergestellten PLEDs oder Displays.

Als Elektrolumineszenzmaterialien im Sinne der Erfindung gelten Materialien, die als aktive Schicht in einer PLED Verwendung finden können. Aktive Schicht bedeutet, daß die Schicht befähigt ist, bei Anlegen eines elektrischen Feldes Licht abzustrahlen (lichtemittierende Schicht) und/oder daß sie die Injektion und/oder den Transport der positiven und/oder negativen Ladungen verbessert (Ladungsinjektions- oder Ladungstransportschicht).

Gegenstand der Erfindung ist daher auch die Verwendung eines erfindungsgemäßen Polymers oder Blends in einer PLED, insbesondere als Elektrolumineszenzmaterial.

Gegenstand der Erfindung ist somit ebenfalls eine PLED mit einer oder mehreren aktiven Schichten, wobei mindestens eine dieser aktiven Schichten ein oder mehrere erfindungsgemäße Polymere enthält. Die aktive Schicht kann beispielsweise eine lichtemittierende Schicht und/oder eine Transportschicht und/oder eine Ladungsinjektionsschicht sein.

Im vorliegenden Anmeldetext und auch in den im Weiteren folgenden Beispielen wird auf die Verwendung erfindungsgemäßer Polymere oder Blends in Bezug auf PLEDs und entsprechende Displays abgezielt. Trotz dieser Beschränkung der Beschreibung ist es für den Fachmann ohne weiteres erfinderisches Zutun möglich, die erfidugsgemäßen Polymere als Halbleiter auch für weitere Verwendungen in anderen elektronischen Devices (Vorrichtungen) zu benutzen, z. B. in organischen Feld-Effekt-Transistoren (O-FETs), in organischen integrierten Schaltungen (O-ICs), in organischen Dünnfilmtransistoren (O-TFTs), in organischen Solarzellen (O-SCs), in organischen Laserdioden (O-Laser), oder in organischen photovoltaischen (OPV) Elementen oder Vorrichtungen, um nur einige Anwendungen zu nennen.

Die Verwendung erfindungsgemäßer Polymere in den entsprechenden Vorrichtungen ist ebenfalls ein Gegenstand der vorliegenden Erfindung.

Die folgenden Beispiele sollen die Erfindung erläutern. Insbesondere sind die darin beschriebenen Merkmale, Eigenschaften und Vorteile der dem betreffenden Beispiel zugrunde liegenden definierten Verbindungen auch auf andere, nicht im Detail aufgeführte, aber unter den Schutzbereich der Ansprüche fallende Verbindungen anwendbar, sofern an anderer Stelle nichts Gegenteiliges gesagt wird.

### Beispiel 1: Synthese von (4-Bromphenyl)-{4-[(E)-2-(4-bromphenyl)-vinyl]-phenyl}-(4-tert-butyl-phenyl)-amin (Erfindungsgemäßes Monomer M1)

### a) Synthese von (4-tert-Butylphenyl)-phenylamin

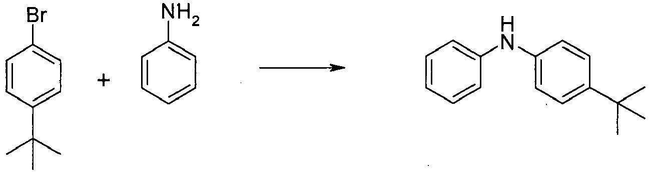

96.4 g (452 mmol) 1-Brom-4-*tert*-butylbenzol und 42.1 g (452 mmol) Anilin werden in Toluol gelöst und 15 min mit N₂ gesättigt. Anschließend werden nacheinander 2.85 g (5 mmol) DPPF, gefolgt von 1.13 g (5 mmol) Pd(OAc)₂ und 56.8 g (588 mmol) NaO*^{t}*Bu zugegeben und für 6 h zum Rückfluss erhitzt. Die organische Phase wird abgetrennt, zweimal mit Wasser gewaschen und über Celite filtriert, mit Toluol nachgespült und einrotiert. Es verbleiben 101 g ockerfarbener Feststoff (99% d. Th.), der ohne weitere Reinigung in die Folgereaktion eingesetzt wird.

### b) Synthese von 2-(4-Bromphenyl)-[1,3]dioxolan

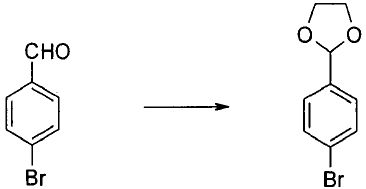

100 g (540 mmol) 4-Brombenzaldehyd werden zusammen mit 200 mg p-Toluolsulfonsäure und 30 mL (540 mmol) Ethylenglycol wasserfrei in 600 mL Toluol vorgelegt und unter DC-Kontrolle am Wasserabscheider zum Rückfluss erhitzt. Nach vollständigem Umsatz wird die Reaktionslösung zweimal mit ges. NaHCO₃-Lösung und einmal mit Wasser gewaschen, über Na₂SO₄ getrocknet und einrotieret. Man erhält 123 g (99% d. Th.) des Dioxolans als gelbes Öl.

### c) Synthese von (4-tert-Butyl-phenyl)-(4-[1,3]dioxolan-2-yl-phenyl)-phenyl-amin

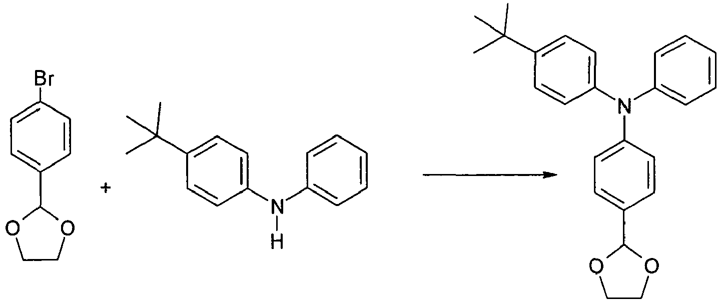

48.8 g (213 mmol) 2-(Bromphenyl)-[1,3]-dioxolan und 48 g (213 mmol) (4-*tert*-Butyl)phenylamin werden in 750 mL in Toluol vorgelegt und die Lösung ca. 30 min. mit N₂ gesättigt. Anschließend werden 29.2 g (304 mmol) Natrium-*tert*-butylat in kleinen Portionen zugegeben, gefolgt von 760 mg (4.2 mmol) Chlor-bis-*t*-Butylphosphin und 485 mg (2.1 mmol) Pd(OAc)₂ zu. Die Mischung wird unter DC-Kontrolle für 3 h zum Rückfluss erhitzt.

Nach vollständigem Umsatz wird das Reaktionsgemisch zweimal mit Wasser gewaschen und die organische Phase über Celite filtriert und einrotiert. Man erhält 79.4 g (99% d. Th.) des Produktes in Form eines gelben Öles.

### d) Synthese von (4-tert-Butylphenyl)-(4-formylphenyl)-4-bromphenylamin

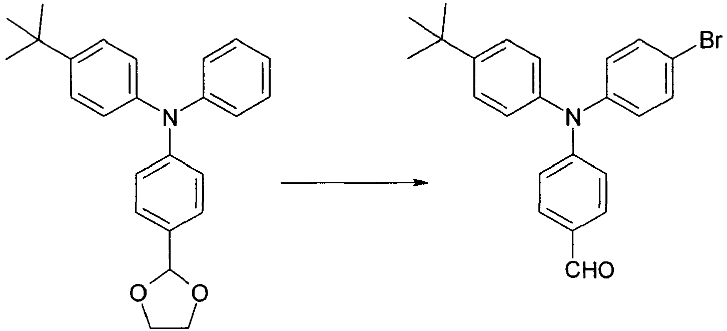

79.9 g (214.0 mmol) des Triphenylamindioxolans werden unter N₂ in 800 mL THF gelöst und bei RT 38.1 g (214.0 mmol) NBS in kleinen Portionen über 1 h zugeben und 1 h gerührt. Der Ansatz wird einrotiertund der Rückstand zwischen Ethylacetat und Wasser verteilet, zweimal mit Wasser gewaschen, über Na₂SO₄ getrocknet und einrotieren. Der verbliebene ölige Rückstand wird in 400 mL 80%iger Essigsäure für 2 h zum Sieden erhitzt. Der nach Abkühlen ausgefallene Feststoff wird abgesaugt und mit Wasser und Methanol gewaschen und getrocknet. Man erhält 87 g (88% d. Th.) des Produkts.

### Synthese von (4-Brombenzyl)-diethylphosphonat

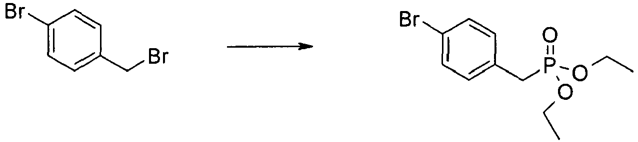

203.6 g (815 mmol) 4-Brombenzylbromid und 215 mL (1.2 mol) Triethylphosphit werden vermischt und unter Gasableitung für 1 h auf 130 °C erhitzt. Danach wird das Produkt fraktionierend destilliert. (2 x 10⁻² mbar, 120 °C). Man erhält 224 g (89%) des Produktes als farblose Flüssigkeit.

### Synthese von (4-Bromphenyl)-{4-[2-(4-bromphenyl)-vinyl]-phenyl}-(4-tert-butyl-phenyl)-amin M1

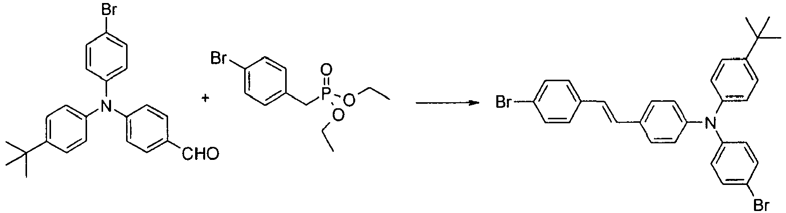

41 g (132 mmol) Phosphonat werden in 400 mL trockenem DMF gelöst, bei ca. 5 °C mit 28 g (265 mmol) NaO*^{t}*Bu versetzt und nach 30 min 49 g (120 mmol) Triphenylaminaldehyd gelöst in 200 mL getrocknetem DMF zugetropft. Nach 2 h werden 500 mL Ethanol sowie 500 mL 4 M HCl zugetropft, der Niederschlag abgesaugt, mit Wasser und EtOH gewaschen und getrocknet. Das Produkt wird durch sechsmalige Umkristallisation aus Heptan bis zu einer Reinheit von >99.9% gereinigt. Es verbleiben 43 g (64%) gelbe, filzige Kristalle.

### Beispiel 2: Synthese weiterer Comonomere

Die Synthese der Monomere M2 bis M5 ist in WO 03/020790 und der darin zitierten Literatur beschrieben.

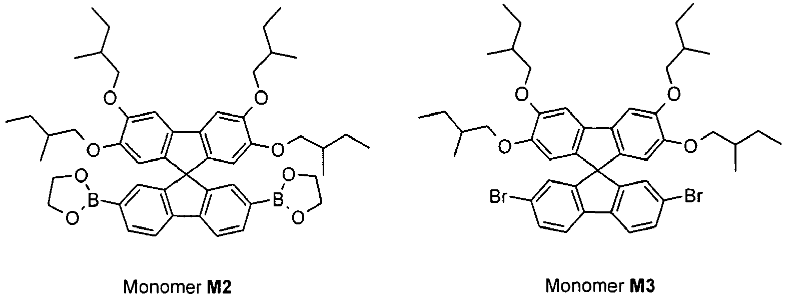

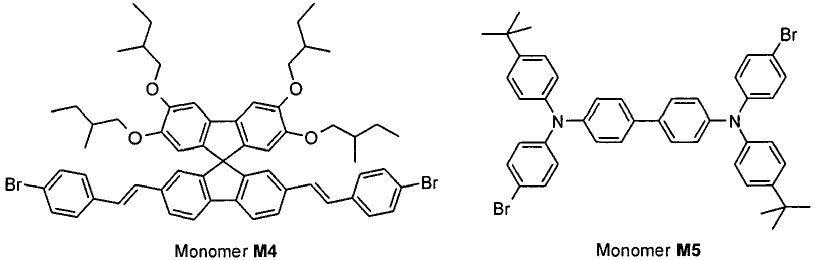

### Beispiel 3: Synthese der Polymere

Die Polymere werden durch SUZUKI-Kupplung gemäß WO 03/048225 synthetisiert. Die Zusammensetzung der synthetisierten Polymere P1 und P2 ist in Tabelle 1 zusammengefasst. Außerdem werden die Vergleichspolymere V1 und V2 synthetisiert, die statt des Monomers M1, das im Polymer zu Einheiten gemäß Formel (1) führt, das Monomer M4 enthalten. Die Zusammensetzung dieser Vergleichspolymere ist ebenfalls in Tabelle 1 aufgeführt.

### Beispiel 4: Herstellung der PLEDs

Die Polymere werden für einen Einsatz in PLEDs untersucht. Die PLEDs sind jeweils Zweischichtsysteme, d. h. Substrat//ITO//PEDOT//Polymer// Kathode. PEDOT ist ein Polythiophen-Derivat (Baytron P, von H. C. Starck, Goslar). Als Kathode wird in allen Fällen Ba/Ag (Aldrich) verwendet. Wie PLEDs dargestellt werden können, ist in WO 04/037887 und der darin zitierten Literatur ausführlich beschrieben.

### Beispiel 5: Device-Beispiele

Die Ergebnisse, die bei Verwendung der Polymere P1 und P2 in PLEDs erhalten wurden, sind in Tabelle 1 zusammengefasst. Ebenso aufgeführt sind die Elektrolumineszenz-Ergebnisse, die unter Verwendung der Vergleichspolymere V1 und V2 erhalten wurden.

Wie man aus den Ergebnissen erkennen kann, ist die Effizienz der erfindungsgemäßen Polymere besser als die der Vergleichspolymere. Die Emissionsfarbe ist vergleichbar und die Lebensdauern sind dies berücksichtigend deutlich verbessert. Dies zeigt, dass die erfindungsgemäßen Polymere besser für den Einsatz in Displays geeignet sind als Polymere gemäß dem Stand der Technik.

**Tabelle 1: Device-Ergebnisse**

| Beispiel | Polymer | Monomere | Max.Eff./ cd/A | U@100 cd/m² / V | CIE x/y^{a} | Lebensdauer^{b}/ h |
|---|---|---|---|---|---|---|
| 5 | **P1** | 10% **M1** | 5,02 | 3,7 | 0,16/0,27 | 250 |
| | | 50% **M2** | | | | |
| | | 30% **M3** | | | | |
| | | 10% **M5** | | | | |
| 6 | **P2** | 2% **M1** | 6,35 | 4,1 | 0.15/0.18 | 1600 |
| | | 50% **M2** | | | | |
| | | 46% **M3** | | | | |
| | | 2% **M5** | | | | |
| 7 | **V1^{c}** | 50% **M2** | 4,66 | 3,9 | 0,17/0,30 | 180 |
| | | 30% **M3** | | | | |
| | | 10% **M5** | | | | |
| | | 10% **M4** | | | | |
| 8 | **V2^{c}** | 50% **M2** | 4.70 | 4.7 | 0,17/0,26 | 449 |
| | | 46% **M3** | | | | |
| | | 2% **M5** | | | | |
| | | 2% **M4** | | | | |

| | | | | | | |
|---|---|---|---|---|---|---|
| ^{a} CIE-Koordinaten: Farbkoordinaten der Commision Internationale de l'Eclairage 1931 ^{b} Lebensdauer: Zeit bis zum Abfall der Helligkeit auf 50 % der Anfangshelligkeit, Anfangshelligkeit 400 cd/m² ^{c} Vergleichspolymere | | | | | | |

## Patentansprüche

1. Konjugierte Polymere, **dadurch gekennzeichnet, daß** sie 1 bis 30 mol% einer oder mehrerer Einheiten gemäß Formel (1) enthalten 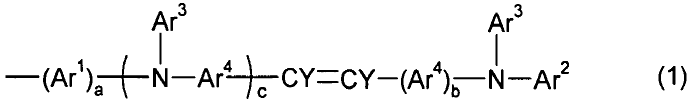 wobei die verwendeten Symbole und Indizes folgende Bedeutung besitzen:
Ar¹ ist bei jedem Auftreten gleich oder verschieden Phenyl oder Phenylen, welches ein- oder mehrfach durch R¹ substituiert sein kann,
Ar² ist bei jedem Auftreten gleich oder verschieden Phenyl oder Phenylen, welches ein- oder mehrfach durch R² substituiert sein kann,
Ar³ ist bei jedem Auftreten gleich oder verschieden Phenyl oder Phenylen, welches ein- oder mehrfach durch R³ substituiert sein kann,
Ar⁴ ist bei jedem Auftreten gleich oder verschieden Phenylen, 4,4'-Biphenylen, 9,9-disubstituiertem Fluoren-2,7-diyl, 6,6,12,12-tetrasubstituiertem Indenofluoren-2,8-diyl oder Spirobifluoren-2,7-diyl, wobei diese Gruppen ein- oder mehrfach durch R⁵ substituiert sein können, und R⁵ eine der für R⁴ angegebenen Bedeutungen besitzt,
Y ist bei jedem Auftreten H,
R¹⁻⁴ ist bei jedem Auftreten gleich oder verschieden H, oder ein Kohlenwasserstoffrest mit 1 bis 40 C-Atomen, wobei auch zwei oder mehrere der Reste R¹⁻⁴ miteinander ein aliphatisches oder aromatisches, mono- oder polycyclisches Ringsystem bilden können, R¹, R² und R³ können auch eine kovalente Verknüpfung im Polymer bedeuten,
a ist bei jedem Auftreten gleich oder verschieden 1, 2 oder 3,
b ist bei jedem Auftreten gleich oder verschieden 1, 2 oder 3,
c ist bei jedem Auftreten gleich oder verschieden 0 oder 1,
sowie weitere Struktureinheiten
ausgewählt aus den Gruppen der Fluorenylene, Spirobifluorenylene, Dihydrophenanthrenylene, Tetrahydropyrenylene, Stilbenylene, Bisstyrylarylene, 1,4-Phenylene, 1,4-Naphthylene, 1,4- oder 9,10-Anthrylene, 1,6- oder 2,7- oder 4,9-Pyrenylene, 3,9- oder 3,10-Perylenylene, 2,7- oder 3,6-Phenanthrenylene, 4,4'-Biphenylylene, 4,4"-Terphenylylene oder 4,4'-bei-1,1'-naphthylylene,
ausgewählt aus den Gruppen der Triarylamine, Triarylphosphine, Benzidine, Tetraarylen-para-phenylendiamine, Phenothiazine, Phenoxazine, Dihydrophenazine, Thianthrene, Dibenzo-*p*-dioxine, Phenoxathiine, Carbazole, Azulene, Thiophene, Pyrrole oder Furane, und/oder
ausgewählt aus aus den Gruppen der Pyridine, Pyrimidine, Pyridazine, Pyrazine, Anthracene, Triarylborane, Oxadiazole, Chinoline, Chinoxaline oder Phenazine.

2. Polymere gemäß Anspruch 1, **dadurch gekennzeichnet, daß** die Einheiten der Formel (1) in Konjugation zur Polymerhauptkette stehen.

3. Polymere gemäß Anspruch 1 oder 2, **dadurch gekennzeichnet, daß** die Einheiten gemäß Formel (1) in die Hauptkette des Polymers eingebaut sind.

4. Polymere gemäß Anspruch 1 oder 2, **dadurch gekennzeichnet, daß** die Einheiten gemäß Formel (1) in die Seitenkette des Polymers eingebaut sind.

5. Polymere gemäß einem oder mehreren der Ansprüche 1 bis 4, **dadurch gekennzeichnet, daß** die Einheiten gemäß Formel (1) aus folgenden Unterformeln ausgewählt sind: 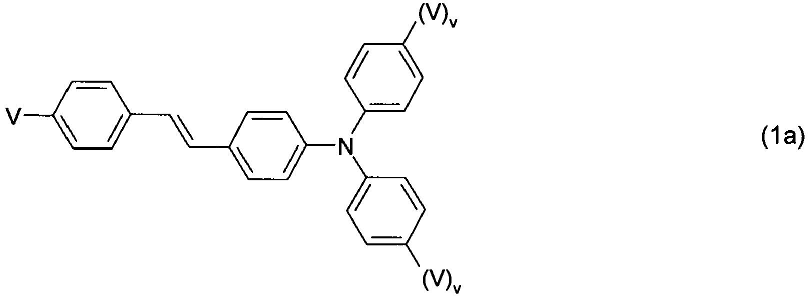 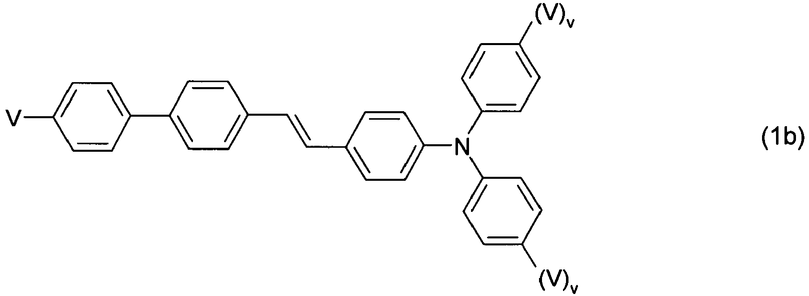 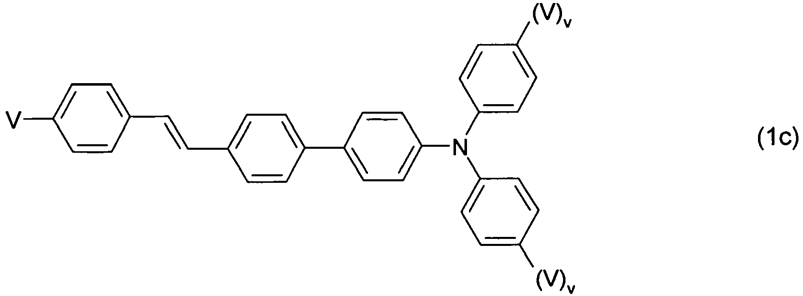 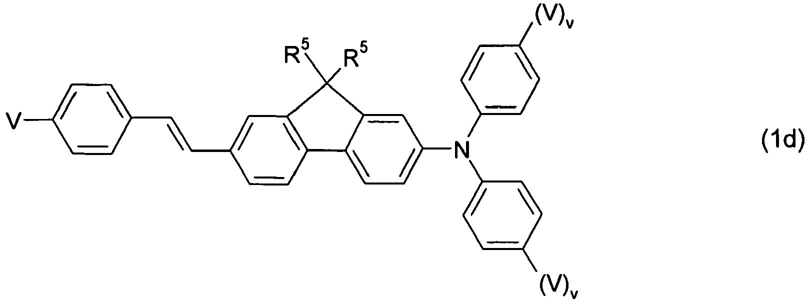 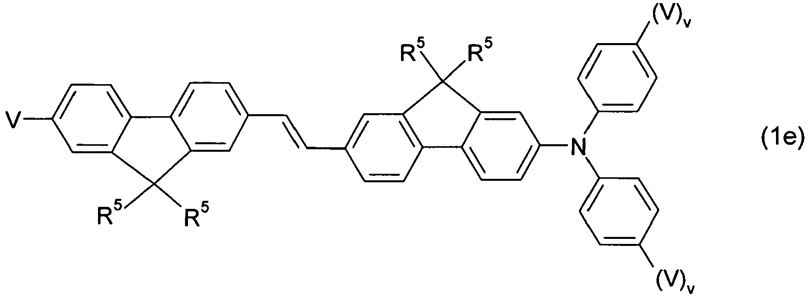 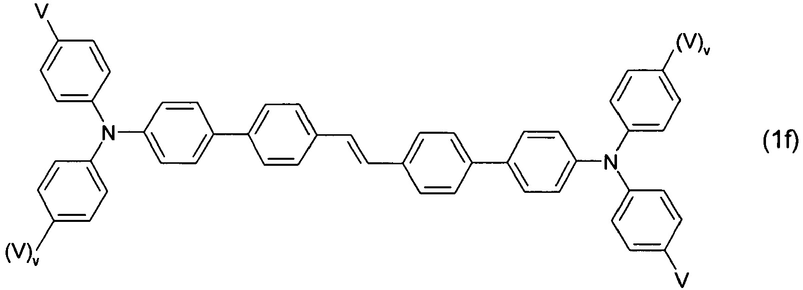 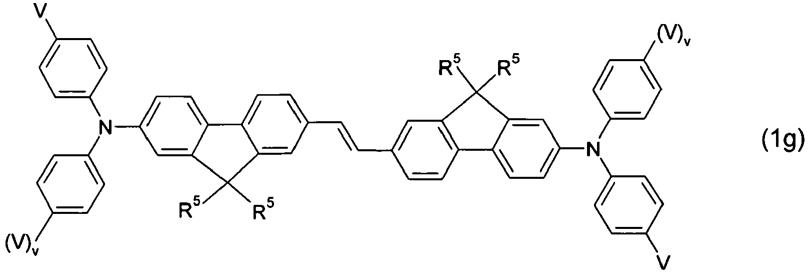 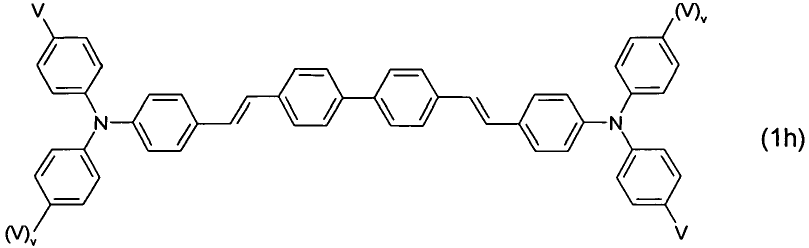 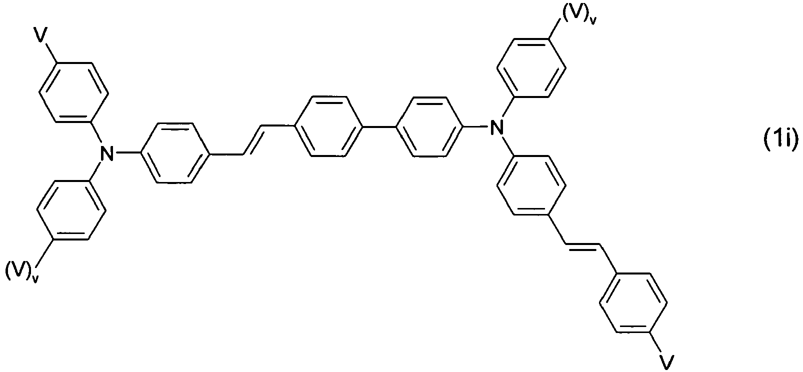 worin V eine kovalente Verknüpfung im Polymer und v 0 oder 1 bedeutet, R⁵ bei jedem Auftreten gleich oder verschieden eine der für R⁴ in Anspruch 1 angegebenen Bedeutungen besitzt, und die Phenylringe auch ein- oder mehrfach durch R⁵ substituiert sein können.

6. Polymere gemäß einem oder mehreren der Ansprüche 1 bis 5, **dadurch gekennzeichnet, daß** sie mindestens 50 mol% Einheiten ausgewählt aus den Gruppen der Fluorenylene, Spirobifluorenylene, Dihydrophenanthrenylene, Tetrahydropyrenylene, Stilbenylene, Bisstyrylarylene, 1,4-Phenylene, 1,4-Naphthylene, 1,4- oder 9,10-Anthrylene, 1,6- oder 2,7- oder 4,9-Pyrenylene, 3,9- oder 3,10-Perylenylene, 2,7- oder 3,6-Phenanthrenylene, 4,4'-Biphenylylene, 4,4"-Terphenylylene oder 4,4'-Bi-1,1'-naphthylylene und 2 - 30 mol% Einheiten
ausgewählt aus den Gruppen der Triarylamine, Triarylphosphine, Benzidine, Tetraarylen-para-phenylendiamine, Phenothiazine, Phenoxazine, Dihydrophenazine, Thianthrene, Dibenzo-*p*-dioxine, Phenoxathiine, Carbazole, Azulene, Thiophene, Pyrrole oder Furane und/oder
ausgewählt aus aus den Gruppen der Pyridine, Pyrimidine, Pyridazine, Pyrazine, Anthracene, Triarylborane, Oxadiazole, Chinoline, Chinoxaline oder Phenazine enthalten.

7. Polymere gemäß einem oder mehreren der Ansprüche 1 bis 6, **dadurch gekennzeichnet, daß** der Anteil Struktureinheiten gemäß Formel (1) 1 bis 10 mol% beträgt.

8. Blend eines oder mehrerer Polymere gemäß einem oder mehreren der Ansprüche 1 bis 7 mit einer oder mehreren weiteren polymeren, oligomeren, dendritischen oder niedermolekularen Substanzen.

9. Monomere Verbindungen gemäß Formel (1) 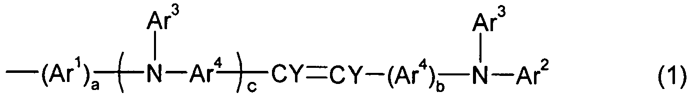 worin Ar¹⁻⁴, a, b und c die in Anspruch 1 angegebenen Bedeutungen besitzen, und worin einer der Substituenten R¹ an Ar¹ und gegebenenfalls einer der Substituenten R² an Ar² und/oder einer der Substituenten R³ an Ar³ jeweils unabhängig voneinander eine reaktive Gruppe Z bedeuten, die für eine Polymerisationsreaktion geeignet ist, **dadurch gekennzeichnet, daß** Z¹ und Z² jeweils unabhängig voneinander für Cl, Br, I, O-Tosylat, O-Triflat, O-SO₂R', B(OH)₂, B(OR')₂ oder Sn(R')₃ stehen, worin R' optional substituiertes Alkyl oder Aryl bedeutet und zwei Gruppen R' ein aromatisches oder aliphatisches, mono- oder polycyclisches Ringsystem bilden können.

10. Monomere gemäß Anspruch 9, **dadurch gekennzeichnet, daß** sie aus den Unterformeln (1a) - (1 i) gemäß Anspruch 5 ausgewählt sind, worin die Reste V jeweils unabhängig voneinander Z bedeuten wie in Anspruch 9 definiert.

11. Lösungen und Formulierungen enthaltend ein oder mehrere erfindungsgemäße Polymere oder Blends gemäß einem oder mehreren der Ansprüche 1 bis 8 in einem oder mehreren Lösungsmitteln.

12. Verwendung von Polymeren, Blends, Lösungen oder Formulierungen gemäß einem oder mehreren der Ansprüche 1 bis 8 und 11 in einem elektronischen Bauteil, vorzugsweise in einer organischen Leuchtdiode (OLED).

13. Elektronisches Bauteil enthaltend ein oder mehrere Polymere oder Blends gemäß einem oder mehreren der Ansprüche 1 bis 8.

14. Elektronisches Bauteil gemäß Anspruch 13, **dadurch gekennzeichnet, daß** es sich um einen organischen Feld-Effekt-Transistor (O-FET), organischen Dünnfilmtransistor (O-TFT), organische integrierte Schaltung (O-IC), organische Solarzelle (O-SC), organische Leuchtdiode (OLED), organische Laserdiode (O-Laser) oder organisches photovoltaisches (OPV) Element oder Vorrichtung handelt.

15. Organische Leuchtdiode gemäß Anspruch 14, **dadurch gekennzeichnet, daß** diese eine oder mehrere Schichten enthaltend ein oder mehrere Polymere oder Blends gemäß einem oder mehreren der Ansprüche 1 bis 8 enthält.

## Claims

1. Conjugated polymers, **characterised in that** they contain 1 to 30 mol% of one or more units of the formula (1) 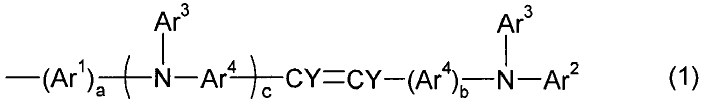 where the symbols and indices used have the following meanings:
Ar¹ is on each occurrence, identically or differently, phenyl or phenylene, each of which may be mono- or polysubstituted by R¹,
Ar² is on each occurrence, identically or differently, phenyl or phenylene, each of which may be mono- or polysubstituted by R²,
Ar³ is on each occurrence, identically or differently, phenyl or phenylene, each of which may be mono- or polysubstituted by R³,
Ar⁴ is on each occurrence, identically or differently, phenylene, 4,4'-biphenylene, 9,9-disubstituted fluorene-2,7-diyl, 6,6,12,12-tetrasubstituted indenofluorene-2,8-diyl or spirobifluorene-2,7-diyl, where these groups may be mono- or polysubstituted by R⁵, and R⁵ has one of the meanings indicated for R⁴,
Y is on each occurrence H,
R¹⁻⁴ are on each occurrence, identically or differently, H, or a hydrocarbon radical having 1 to 40 C atoms, in which, in addition, two or more of the radicals R¹⁻⁴ may form an aliphatic or aromatic, mono- or polycyclic ring system with one another, R¹, R² and R³ may also denote a covalent link in the polymer,
a is on each occurrence, identically or differently, 1, 2 or 3,
b is on each occurrence, identically or differently, 1, 2 or 3,
c is on each occurrence, identically or differently, 0 or 1,
and further structural units
selected from the groups of the fluorenylenes, spirobifluorenylenes, dihydrophenanthrenylenes, tetrahydropyrenylenes, stilbenylenes, bisstyrylarylenes, 1,4-phenylenes, 1,4-naphthylenes, 1,4- or 9,10-anthrylenes, 1,6- or 2,7- or 4,9-pyrenylenes, 3,9- or 3,10-perylenyl-enes, 2,7- or 3,6-phenanthrenylenes, 4,4'-biphenylylenes, 4,4"-ter-phenylylenes or 4,4'-bis-1,1'-naphthylylenes,
selected from the groups of the triarylamines, triarylphosphines, benzidines, tetraarylene-para-phenylenediamines, phenothiazines, phenoxazines, dihydrophenazines, thianthrenes, dibenzo-p-dioxins, phenoxathiynes, carbazoles, azulenes, thiophenes, pyrroles or furans, and/or
selected from the groups of the pyridines, pyrimidines, pyridazines, pyrazines, anthracenes, triarylboranes, oxadiazoles, quinolines, quinoxalines or phenazines.

2. Polymers according to Claim 1, **characterised in that** the units of the formula (1) are in conjugation with the polymer main chain.

3. Polymers according to Claim 1 or 2, **characterised in that** the units of the formula (1) are incorporated into the main chain of the polymer.

4. Polymers according to Claim 1 or 2, **characterised in that** the units of the formula (1) are incorporated into the side chain of the polymer.

5. Polymers according to one or more of Claims 1 to 4, **characterised in that** the units of the formula (1) are selected from the following sub-formulae: 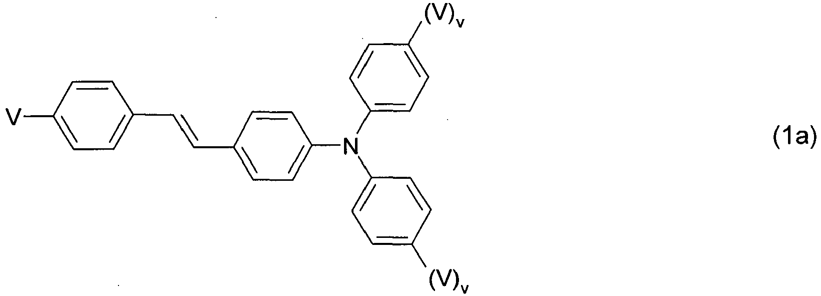 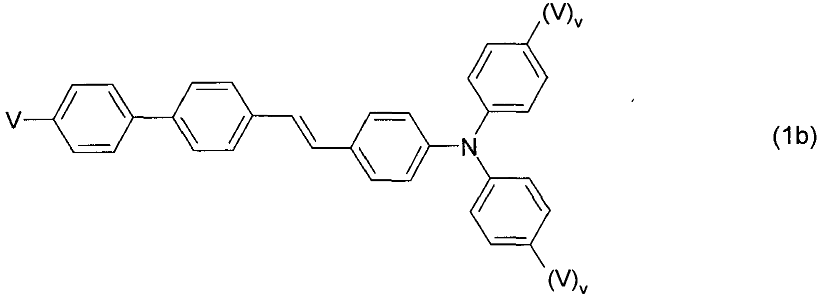 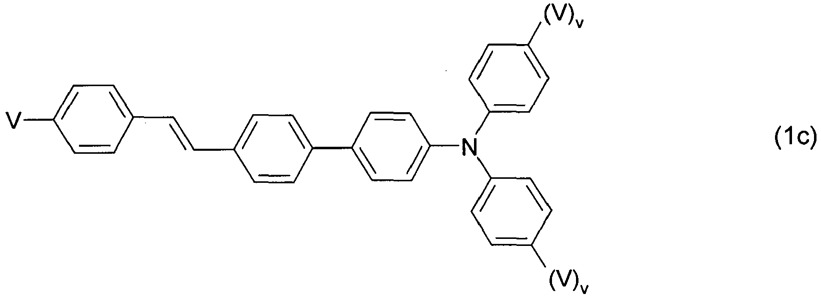 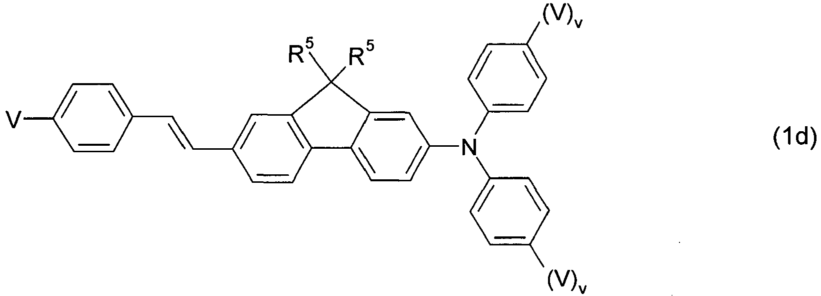 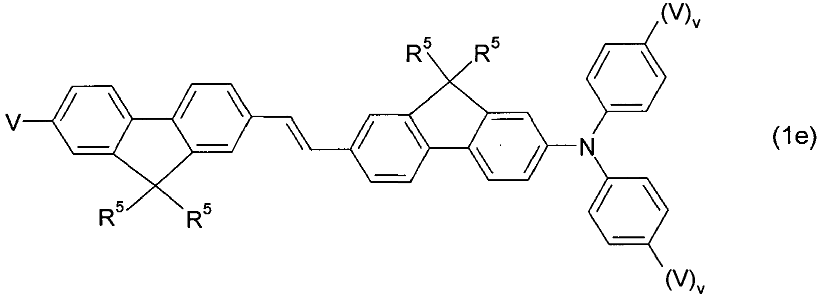 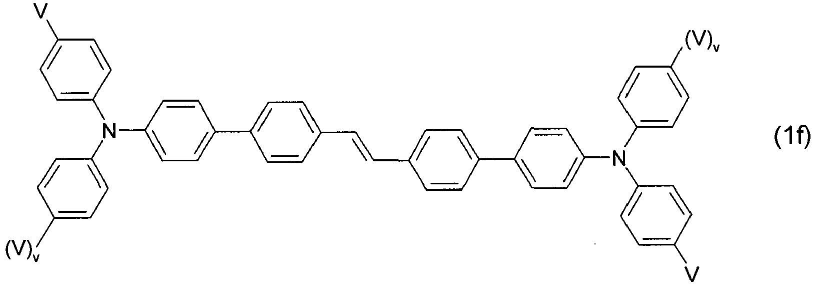 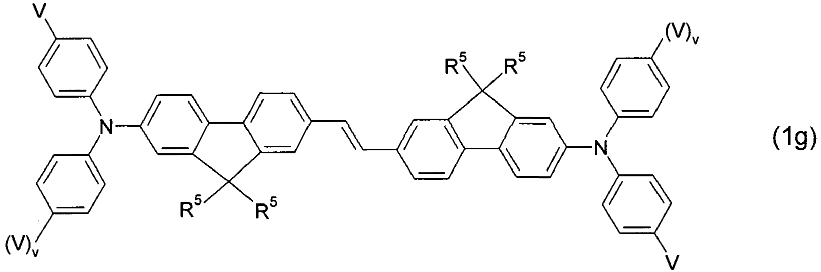 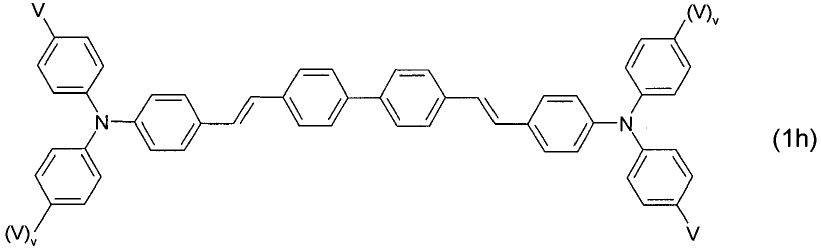 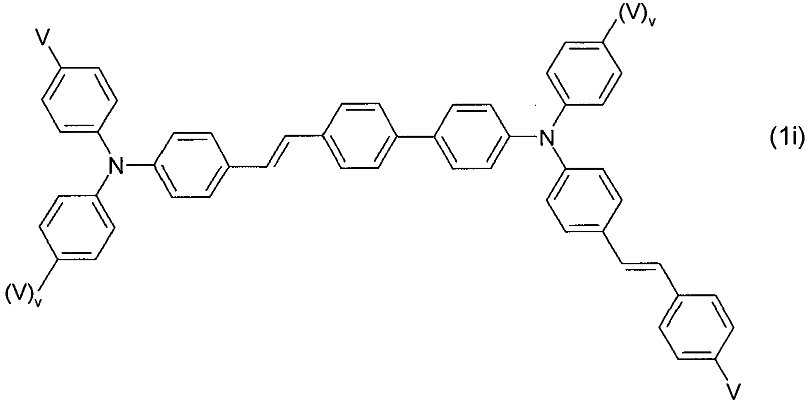 in which V denotes a covalent link in the polymer and v denotes 0 or 1, R⁵ on each occurrence, identically or differently, has one of the meanings indicated for R⁴ in Claim 1, and the phenyl rings may also be mono- or polysubstituted by R⁵.

6. Polymers according to one or more of Claims 1 to 5, **characterised in that** they contain at least 50 mol% of units
selected from the groups of the fluorenylenes, spirobifluorenylenes, dihydrophenanthrenylenes, tetrahydropyrenylenes, stilbenylenes, bisstyrylarylenes, 1,4-phenylenes, 1,4-naphthylenes, 1,4- or 9,10-anthrylenes, 1,6- or 2,7- or 4,9-pyrenylenes, 3,9- or 3,10-perylenylenes, 2,7- or 3,6-phenanthrenylenes, 4,4'-biphenylylenes, 4,4"-terphenylylenes or 4,4'-bi-1,1'-naphthylylenes and 2 - 30 mol% of units
selected from the groups of the triarylamines, triarylphosphines, benzidines, tetraarylene-para-phenylenediamines, phenothiazines, phenoxazines, dihydrophenazines, thianthrenes, dibenzo-p-dioxins, phenoxathiynes, carbazoles, azulenes, thiophenes, pyrroles or furans and/or
selected from the groups of the pyridines, pyrimidines, pyridazines, pyrazines, anthracenes, triarylboranes, oxadiazoles, quinolines, quinoxalines or phenazines.

7. Polymers according to one or more of Claims 1 to 6, **characterised in that** the proportion of structural units of the formula (1) is 1 to 10 mol%.

8. Blend of one or more polymers according to one or more of Claims 1 to 7 with one or more further polymeric, oligomeric, dendritic or low-molecular-weight substances.

9. Monomeric compounds of the formula (1) 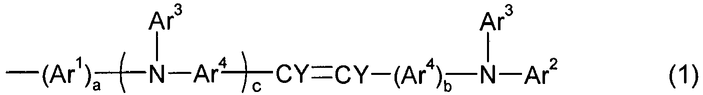 in which Ar¹⁻⁴, a, b and c have the meanings indicated in Claim 1 and in which one of the substituents R¹ on Ar¹ and optionally one of the substituents R² on Ar² and/or one of the substituents R³ on Ar³ each, independently of one another, denote a reactive group Z which is suitable for a polymerisation reaction, **characterised in that** Z¹ and Z² each, independently of one another, stand for Cl, Br, I, O-tosylate, O-triflate, O-SO₂R', B(OH)₂, B(OR')₂ or Sn(R')₃, in which R' denotes optionally substituted alkyl or aryl and two groups R' may form an aromatic or aliphatic, mono- or polycyclic ring system.

10. Monomers according to Claim 9, **characterised in that** they are selected from the sub-formulae (1a) - (1i) according to Claim 5 in which the radicals V each, independently of one another, denote Z as defined in Claim 9.

11. Solutions and formulations comprising one or more polymers or blends according to the invention according to one or more of Claims 1 to 8 in one or more solvents.

12. Use of polymers, blends, solutions or formulations according to one or more of Claims 1 to 8 and 11 in an electronic component, preferably in an organic light-emitting diode (OLED).

13. Electronic component comprising one or more polymers or blends according to one or more of Claims 1 to 8.

14. Electronic component according to Claim 13, **characterised in that** it is an organic field-effect transistor (O-FET), organic thin-film transistor (O-TFT), organic integrated circuit (O-IC), organic solar cell (O-SC), organic light-emitting diode (OLED), organic laser diode (O-laser) or organic photovoltaic (OPV) element or device.

15. Organic light-emitting diode according to Claim 14, **characterised in that** it comprises one or more layers comprising one or more polymers or blends according to one or more of Claims 1 to 8.

## Revendications

1. Polymères conjugués, **caractérisés en ce qu'**ils contiennent 1 à 30 mol% (pourcentage molaire) d'une ou de plusieurs unité(s) de la formule (1) : 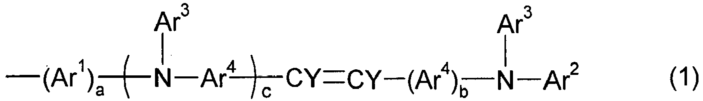 dans laquelle les symboles et indices utilisés présentent les significations qui suivent :
Ar¹ est, pour chaque occurrence, de manière identique ou différente, phényle ou phénylène, dont chacun peut être monosubstitué ou polysubstitué par R¹,
Ar² est, pour chaque occurrence, de manière identique ou différente, phényle ou phénylène, dont chacun peut être monosubstitué ou polysubstitué par R²,
Ar³ est, pour chaque occurrence, de manière identique ou différente, phényle ou phénylène, dont chacun peut être monosubstitué ou polysubstitué par R³,
Ar⁴ est, pour chaque occurrence, de manière identique ou différente, phénylène, 4,4'-biphénylène, fluorène-2,7-diyle 9,9-disubstitué, indénofluorène-2,8-diyle 6,6,12,12-tétrasubstitué ou spiro-bifluorène-2,7-diyle, où ces groupes peuvent être monosubstitués ou polysubstitués par R⁵, et R⁵ présente l'une des significations indiquées pour R⁴,
Y est, pour chaque occurrence, H,
R¹⁻⁴ sont, pour chaque occurrence, de manière identique ou différente, H, ou un radical hydrocarbone comportant 1 à 40 atome(s) de C, où, en outre, deux des radicaux R¹⁻⁴ ou plus peuvent former un système de cycle monocyclique ou polycyclique aliphatique ou aromatique l'un avec l'autre ou les uns avec les autres, R¹, R² et R³ peuvent également représenter une liaison covalente dans le polymère,
a est, pour chaque occurrence, de manière identique ou différente, 1, 2 ou 3,
b est, pour chaque occurrence, de manière identique ou différente, 1, 2 ou 3,
c est, pour chaque occurrence, de manière identique ou différente, 0 ou 1,
et d'autres unités structurelles
choisies parmi les groupes constitués par les fluorénylènes, les spirobifluorénylènes, les dihydrophénanthrénylènes, les tétrahydropyrénylènes, les stilbénylènes, les bisstyrylarylènes, les 1,4-phénylènes, les 1,4-naphtylènes, les 1,4- ou 9,10-anthrylènes, les 1,6- ou 2,7- ou 4,9-pyrénylènes, les 3,9- ou 3,10-pérylénylènes, les 2,7- ou 3,6-phénanthrénylènes, les 4,4'-biphénylylènes, les 4,4"-terphénylylènes ou les 4,4'-bi-1,1'-naphtylylènes,
choisies parmi les groupes constitués par les triarylamines, les triarylphosphines, les benzidines, les tétraarylène-para-phénylènediamines, les phénothiazines, les phénoxazines, les dihydrophénazines, les thianthrènes, les dibenzo-p-dioxines, les phénoxathiynes, les carbazoles, les azulènes, les thiophènes, les pyrroles ou les furanes, et/ou
choisies parmi les groupes constitués par les pyridines, les pyrimidines, les pyridazines, les pyrazines, les anthracènes, les triarylboranes, les oxadiazoles, les quinolines, les quinoxalines ou les phénazines.

2. Polymères selon la revendication 1, **caractérisés en ce que** les unités de la formule (1) sont en conjugaison avec la chaîne principale de polymère.

3. Polymères selon la revendication 1 ou 2, **caractérisés en ce que** les unités de la formule (1) sont incorporées dans la chaîne principale du polymère.

4. Polymères selon la revendication 1 ou 2, **caractérisés en ce que** les unités de la formule (1) sont incorporées dans la chaîne latérale du polymère.

5. Polymères selon une ou plusieurs des revendications 1 à 4, **caractérisés en ce que** les unités de la formule (1) sont choisies parmi les sous-formules qui suivent : 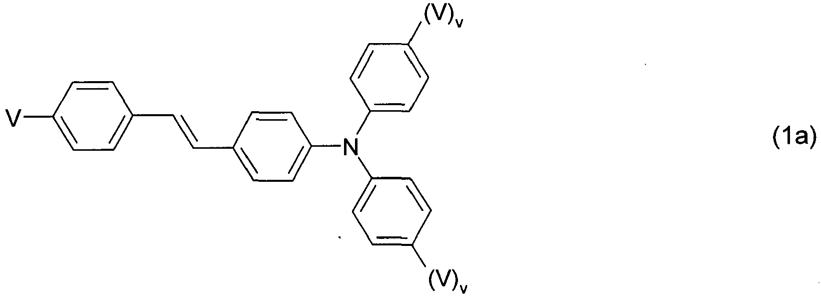 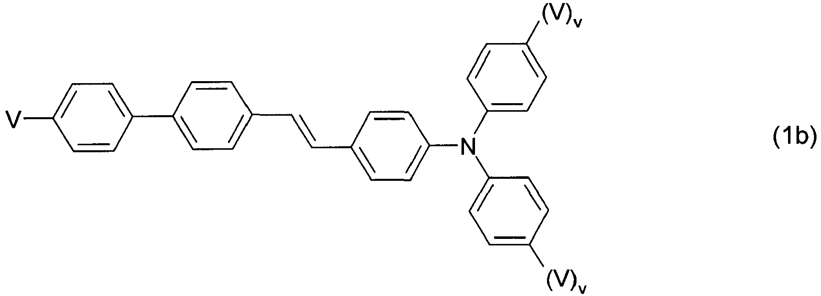 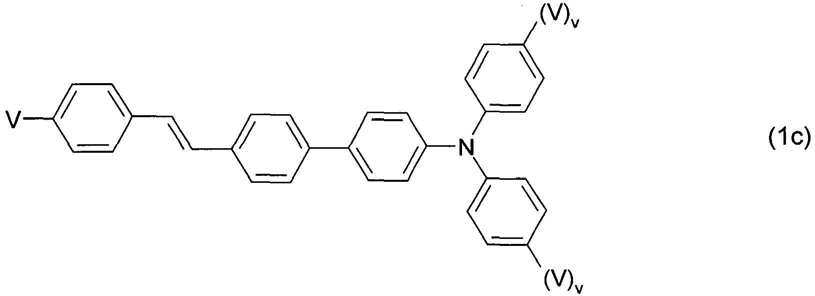 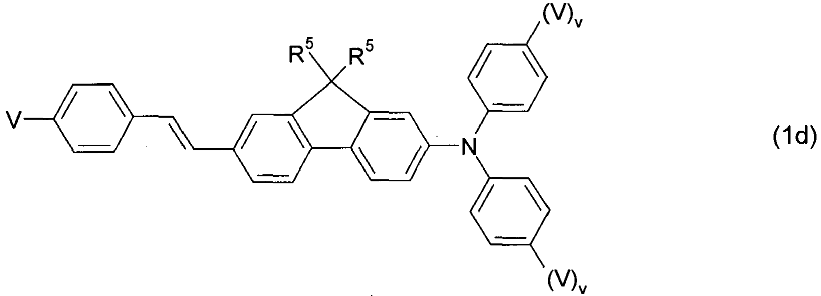 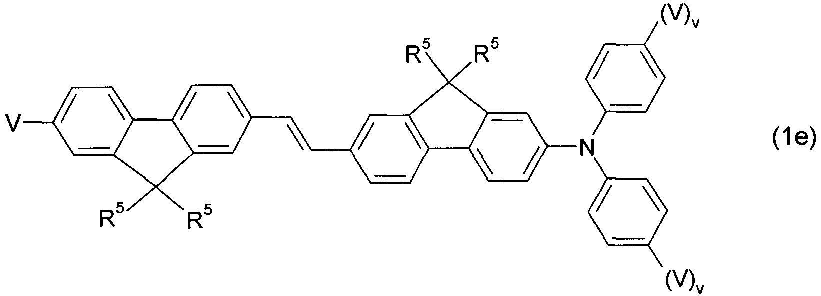 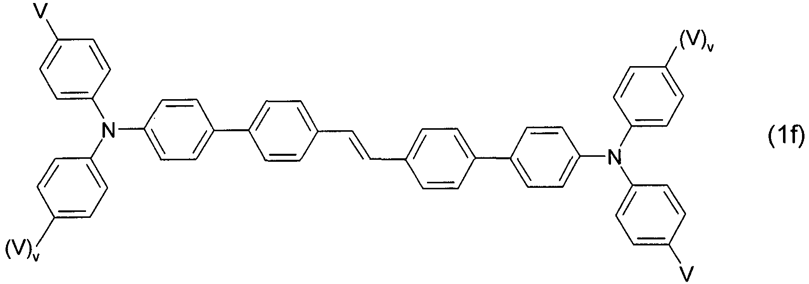 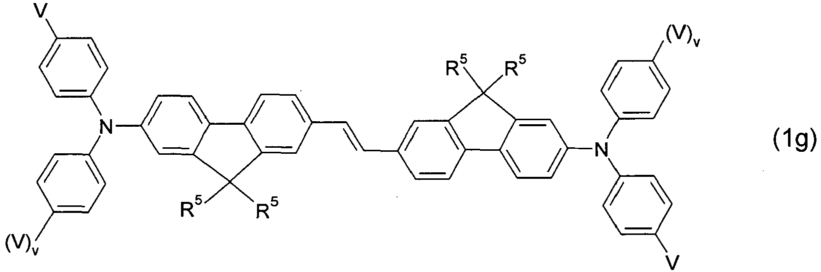 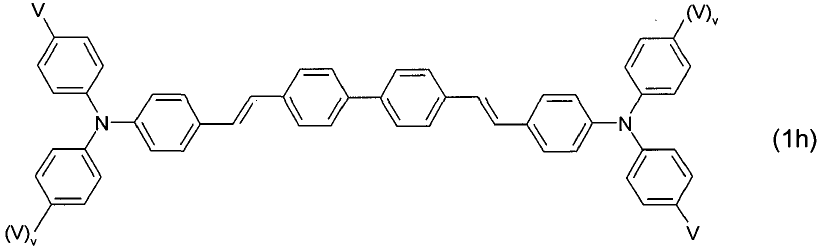 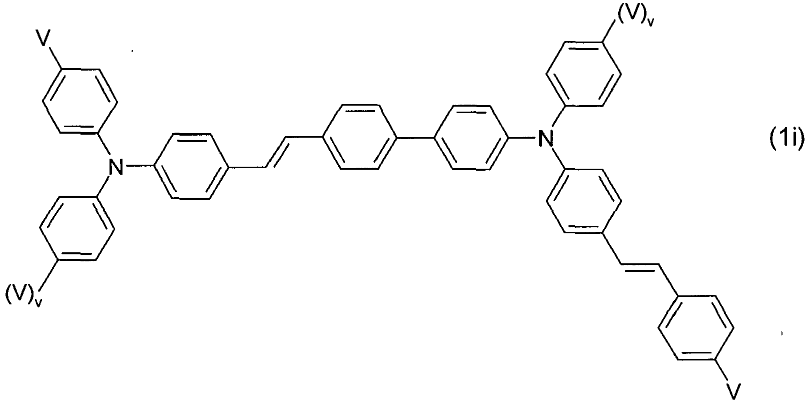 dans lesquelles V représente une liaison covalente dans le polymère et v représente 0 ou 1, R⁵ présente, pour chaque occurrence, de manière identique ou différente, l'une des significations indiquées pour R⁴ selon la revendication 1, et les cycles phényle peuvent également être monosubstitués ou polysubstitués par R⁵.

6. Polymères selon une ou plusieurs des revendications 1 à 5, **caractérisés en ce qu'**ils contiennent au moins 50 mol% (pourcentage molaire) d'unités
choisies parmi les groupes constitués par les fluorénylènes, les spirobifluorénylènes, les dihydrophénanthrénylènes, les tétrahydropyrénylènes, les stilbénylènes, les bisstyrylarylènes, les 1,4-phénylènes, les 1,4-naphtylènes, les 1,4- ou 9,10-anthrylènes, les 1,6- ou 2,7- ou 4,9-pyrénylènes, les 3,9- ou 3,10-pérylènylènes, les 2,7- ou 3,6-phénanthrénylènes, les 4,4'-biphénylylènes, les 4,4"-terphénylylènes ou les 4,4'-bi-1,1'-naphtylylènes et 2 - 30 mol% (pourcentage molaire) d'unités choisies parmi les groupes constitués par les triarylamines, les triarylphosphines, les benzidines, les tétraarylène-para-phénylènediamines, les phénothiazines, les phénoxazines, les dihydrophénazines, les thianthrènes, les dibenzo-*p*-dioxines, les phénoxathiynes, les carbazoles, les azulènes, les thiophènes, les pyrroles ou les furanes et/ou
choisies parmi les groupes constitués par les pyridines, les pyrimidines, les pyridazines, les pyrazines, les anthracènes, les triarylboranes, les oxadiazoles, les quinolines, les quinoxalines ou les phénazines.

7. Polymères selon une ou plusieurs des revendications 1 à 6, **caractérisés en ce que** la proportion d'unités structurelles de la formule (1) est de 1 à 10 mol% (pourcentage molaire).

8. Mélange d'un ou de plusieurs polymère(s) selon une ou plusieurs des revendications 1 à 7 avec une ou plusieurs autre(s) substance(s) polymériques, oligomériques, dendritiques ou de poids moléculaire faible.

9. Composés monomériques de la formule (1) : 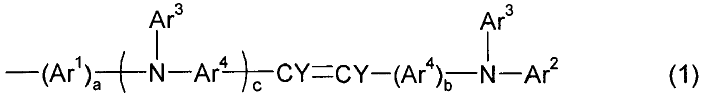 dans laquelle Ar¹⁻⁴, a, b et c présentent les significations indiquées selon la revendication 1 et dans laquelle l'un des substituants R¹ sur Ar¹ et, en option, l'un des substituants R² sur Ar² et/ou l'un des substituants R³ sur Ar³, chacun indépendamment des autres, représentent, un groupe réactif Z qui convient pour une réaction de polymérisation, **caractérisés en ce que** Z¹ et Z² représentent, chacun indépendamment de l'autre, Cl, Br, I, O-tosylate, O-triflate, O-SO₂R', B(OH)₂, B(OR')₂ ou Sn(R')₃, où R' représente des groupes alkyle ou aryle en option substitués et deux groupes R' peuvent former un système de cycle monocyclique ou polycyclique aromatique ou aliphatique.

10. Monomères selon la revendication 9, **caractérisés en ce qu'**ils sont choisis parmi les sous-formules (1a) - (1i) selon la revendication 5 dans lesquelles les radicaux V représentent, chacun indépendamment des autres, Z comme défini selon la revendication 9.

11. Solutions et formulations comprenant un ou plusieurs polymère(s) ou mélange(s) selon l'invention selon une ou plusieurs des revendications 1 à 8 dans un ou plusieurs solvant(s).

12. Utilisation de polymères, de mélanges, de solutions ou de formulations selon une ou plusieurs des revendications 1 à 8 et 11 dans un composant électronique, de façon préférable dans une diode émettrice de lumière organique (OLED).

13. Composant électronique comprenant un ou plusieurs polymère(s) ou mélange(s) selon une ou plusieurs des revendications 1 à 8.

14. Composant électronique selon la revendication 13, **caractérisé en ce qu'**il s'agit d'un transistor à effet de champ organique (O-FET), d'un transistor à film mince organique (O-TFT), d'un circuit intégré organique (O-IC), d'une cellule solaire organique (O-SC), d'une diode émettrice de lumière organique (OLED), d'une diode laser organique (O-laser) ou d'un élément ou dispositif photovoltaïque organique (OPV).

15. Diode émettrice de lumière organique selon la revendication 14, **caractérisée en ce qu'**elle comprend une ou plusieurs couche(s) comprenant un ou plusieurs polymère(s) ou mélange(s) selon une ou plusieurs des revendications 1 à 8.
